(19) Europäisches Patentamt
European Patent Office
Office européen des brevets

(11) EP 4 679 997 A1

(12) **EUROPEAN PATENT APPLICATION**
published in accordance with Art. 153(4) EPC

(43) Date of publication:
**14.01.2026 Bulletin 2026/03**

(21) Application number: **24771096.5**

(22) Date of filing: **05.03.2024**

(51) International Patent Classification (IPC):
***H10K 85/50*** (2023.01) ***H10K 10/46*** (2023.01)
***H10K 71/60*** (2023.01) ***H10K 71/12*** (2023.01)

(52) Cooperative Patent Classification (CPC):
**H10K 10/46; H10K 71/12; H10K 71/60; H10K 85/50**

(86) International application number:
**PCT/KR2024/002777**

(87) International publication number:
**WO 2024/191096 (19.09.2024 Gazette 2024/38)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **10.03.2023 KR 20230031977**
**29.02.2024 KR 20240029337**

(71) Applicant: **POSTECH Research and Business Development Foundation**
**Pohang-si, Gyeongsangbuk-do 37673 (KR)**

(72) Inventors:
- **NOH, Yong-Young**
  **Pohang-si Gyeongsangbuk-do 37673 (KR)**
- **PARK, Geonwoong**
  **Pohang-si Gyeongsangbuk-do 37673 (KR)**
- **LIU, Ao**
  **Pohang-si Gyeongsangbuk-do 37673 (KR)**

(74) Representative: **Stolmár & Partner Patentanwälte PartG mbB**
**Blumenstraße 17**
**80331 München (DE)**

(54) **PEROVSKITE COMPOSITE COMPRISING PSEUDOHALIDE ADDITIVE, ELECTRONIC DEVICE COMPRISING SAME, AND MANUFACTURING METHOD THEREOF**

(57) Disclosed are a perovskite composite comprising a pseudo-halide additive, an electronic device comprising same, and a manufacturing method thereof. The perovskite composite comprises: a tin (Sn) based perovskite; a first additive comprising a pseudo-halide negative ion; and a second additive comprising a tin fluoride ($SnF_2$), and thus pin holes are not formed, and the grain size is large and uniform, resulting in high charge mobility.

FIG. 1

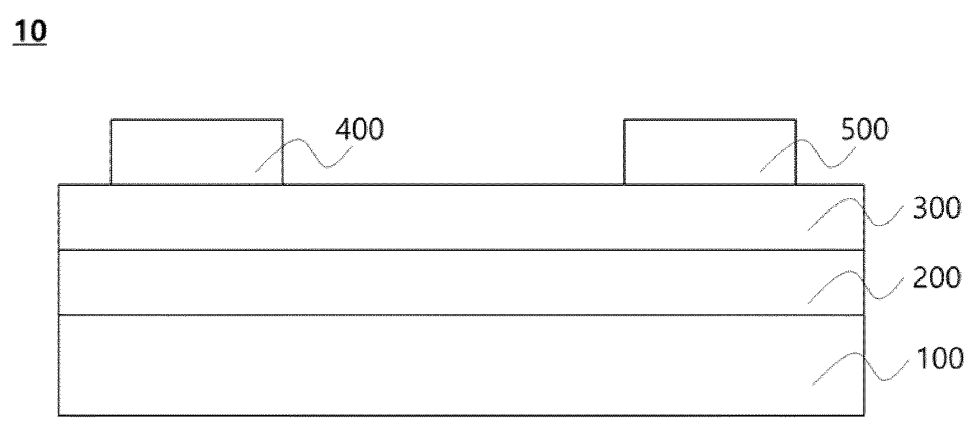




Processed by Luminess, 75001 PARIS (FR)

## Description

### Technical Field

The present disclosure relates to a perovskite composite comprising pseudo-halide additive, electronic device comprising same, and manufacturing method thereof.

### Background Art

Metal halide perovskite materials are used in optoelectronic devices, thus allowing these devices to be used efficiently and stably. However, most perovskite optoelectronic devices are based on lead (Pb), and the toxicity and environmental risks of lead make it difficult to commercially apply in various fields. Therefore, the development of lead-free perovskite materials is required to maintain the performance of superior optoelectronic devices while avoiding environmental hazard.

Research has been conducted on tin halide perovskite as a lead-free perovskite material. However, tin (Sn) is easily oxidized and may form undesirable electron traps. Additionally, the excessive hole concentration (> $10^{18}$ $cm^{-3}$) results in high p-type conductivity, making tin halide perovskite unsuitable to be used as a functional material for optoelectronic devices, which is problematic.

## Disclosure

### Technical Problem

The present disclosure, which has been proposed to solve the problems described above, aims to provide a tin based perovskite composite having a low hole concentration (≤ $10^{15}$ $cm^{-1}$) and thus being usable for an optoelectronic device.

Additionally, the present disclosure aims to provide a p-type thin film transistor with high hole mobility and stability, as well as its manufacturing method.

Additionally, the present disclosure aims to provide optoelectronic devices (e.g., transistors, solar cells, light-emitting diodes, etc.) with high stability by incorporating the aforementioned tin based perovskite composite.

### Technical Solution

According to one aspect of the present disclosure, a perovskite composite is provided, and the perovskite composite comprises: a tin (Sn) based perovskite; a first additive comprising a pseudo-halide anion; and a second additive comprising tin fluoride ($SnF_2$).

In addition, the pseudo-halide anion may be doped to the tin based perovskite.

In addition, the tin fluoride ($SnF_2$) may be doped to the tin based perovskite.

In addition, the pseudo-halide anion and the tin fluoride may be co-doped to the tin based perovskite.

In addition, the pseudo-halide anion may comprise at least one selected from the group consisting of formate, acetate, carbonate, azide, cyanate, thiocyanate, selenocyanate, cyanide, tetrafluoroborate, hexafluorophosphate, and tetrahydrobiopterin.

In addition, the tin based perovskite may be represented by Structural Formula 1 below.

[Structural Formula 1] $A_a(B_{(1-b)}C_b)_cSn(X_{(1-d)}Y_d)_e$

In Structural Formula 1,

A is cesium (Cs),

B and C are different from each other and are each independently methylammonium (MA) or formamidinium (FA),

a is a real number in a range of 0≤a≤1,

b is a real number in a range of 0≤b≤1,

c is a real number in a range of 0≤c≤1,

a and c are not both 0 at the same time,

X and Y are different from each other and are each independently fluorine (F), chlorine (Cl), bromine (Br), or iodine (I),

d is a real number in a range of $0 \leq d \leq 1$, and

e is a real number in a range of $2.5 \leq d \leq 3.5$.

In addition, the perovskite composite may comprise 0.01 to 50 parts by mole of the first additive based on 100 parts by mole of the tin based perovskite.

In addition, the perovskite composite may comprise 0.01 to 50 parts by mole of the second additive based on 100 parts by mole of the tin based perovskite.

In addition, the molar ratio (mol:mol) of the first additive and the second additive may be 10:90 to 90:10.

According to another aspect of the present disclosure, an electronic device including the perovskite composite is provided, and the electronic device comprises any one selected from the group consisting of a transistor, a solar cell, a light-emitting diode, a photodiode, and a photosensor.

According to another aspect of the present disclosure, a perovskite transistor 10 is provided, and the perovskite transistor comprises: a gate electrode 100; an insulating layer 200 positioned on the gate electrode 100; an active layer 300 positioned on the insulating layer 200 and comprising a perovskite composite; and a source electrode 400 and a drain electrode 500 positioned spaced apart from each other on the active layer 300, wherein the perovskite composite comprises a tin (Sn) based perovskite; a first additive comprising a pseudo-halide anion; and a second additive comprising a tin fluoride ($SnF_2$).

In addition, the gate electrode **100** may comprise at least one selected from the group consisting of n-doped silicon (n-doped Si), p-doped silicon (p-doped Si), gold (Au), silver (Ag), platinum (Pt), titanium (Ti), aluminum (Al), tungsten (W), magnesium (Mg), calcium (Ca), ytterbium (Yb), chromium (Cr), nickel (Ni), molybdenum (Mo), gold oxide, platinum oxide, silver oxide, palladium oxide, iron oxide, graphene, carbon nanotube (CNT), silver nanowire (Ag NW), gallium indium eutectic, indium tin oxide, and poly (3,4-ethylenedioxythiophene) polystyrene sulfonate (PEDOT:PSS), and the source electrode **400** and the drain electrode **500** may each comprise at least one selected from the group consisting of gold (Au), silver (Ag), platinum (Pt), titanium (Ti), aluminum (Al), tungsten (W), magnesium (Mg), calcium (Ca), ytterbium (Yb), chromium (Cr), nickel (Ni), molybdenum (Mo), gold oxide, platinum oxide, silver oxide, palladium oxide, iron oxide, graphene, carbon nanotubes (CNT), silver nanowires (Ag nanowires (Ag NW), gallium indium eutectic, indium tin oxide, and poly(3,4-ethylenedioxythiophene) polystyrene sulfonate (PEDOT:PSS).

In addition, the insulating layer **200** may comprise at least one selected from the group consisting of silicon dioxide, glass, quartz, alumina, silicon carbide, magnesium oxide, polyethylene naphthalate (PEN), polyethylene terephthalate (PET), polystyrene (PS), polyimide (PI), polyvinyl chloride (PVC), polyvinyl pyrrolidone (PVP), polyethylene (PE), parylene, silicon oxide ($SiO_2$), germanium, polyvinyl alcohol (PVA), polymethyl methacrylate (PMMA), zirconium oxide ($ZrO_2$), aluminum oxide ($AlO_2$), hafnium oxide ($HfO_2$), and bismuth antimony telluride (BST).

According to another aspect of the present disclosure, a method for manufacturing a perovskite composite is provided, and the method comprises: (a) mixing a first additive comprising a pseudo-halide anion and a second additive comprising a tin fluoride ($SnF_2$) into a first mixed solution comprising a compound represented by Structural Formula 2 below and a tin halide represented by Structural Formula 3 below, thus preparing a second mixed solution; (b) heating the second mixed solution, thus preparing a perovskite precursor solution; and (c) drying and heat-treating the perovskite precursor solution, thus preparing a perovskite composite comprising a tin (Sn) based perovskite; a first additive comprising a pseudo-halide anion; and a second additive comprising a tin fluoride ($SnF_2$).

[Structural formula 2] $A_a(B_{(1-b)}C_b)_c(X_{(1-d)}Y_d)_{e'}$

[Structural formula 3] $Sn(X_{(1-d)}Y_d)_{e''}$

In Structural Formulas 2 and 3 above,

A is cesium (Cs),

B and C are different from each other and are each independently methylammonium (MA) or formamidinium (FA),

a is a real number in a range of $0 \leq a \leq 1$,

b is a real number in a range of $0 \leq b \leq 1$,

c is a real number in a range of $0 \le c \le 1$,

a and c are not 0 at the same time,

X and Y are different from each other and are each independently fluorine (F), chlorine (Cl), bromine (Br), or iodine (I),

d is a real number in a range of $0 \le d \le 1$,

$$e' + e'' = e,$$

and

e is a real number in a range of $2.5 \le d \le 3.5$.

In addition, the perovskite composite may comprise 0.01 to 50 parts by mole of the first additive based on 100 parts by mole of the tin based perovskite.
In addition, the perovskite composite may comprise 0.01 to 50 parts by mole of the second additive based on 100 parts by mole of the tin based perovskite.
In addition, the molar ratio (mol:mol) of the first additive and the second additive may be 10:90 to 90:10.
In addition, the step (b) may be carried out at a temperature in a range of 80 to 150° C.
In addition, the heat treatment of the step (c) may be carried out at a temperature in a range of 100 to 150° C.
According to another aspect of the present disclosure, a method for manufacturing a perovskite transistor is provided, and the method comprises: (1) preparing a gate electrode/insulating layer laminate comprising a gate electrode and an insulating layer positioned on the gate electrode; (2) forming an active layer comprising a perovskite composite on the insulating layer; and (3) forming a source electrode and a drain electrode on the active layer, wherein the perovskite composite comprises a tin(Sn) based perovskite; a first additive comprising a pseudo-halide anion; and a second additive comprising a tin fluoride ($SnF_2$).

## Advantageous Effects

The perovskite composite of the present disclosure can provide a device with higher stability when applied to a device by preventing the oxidation of tin (oxidation of $Sn^{2+}$ to $Sn^{4+}$) by comprising an additive having a pseudo-halide anion.
In addition, the perovskite composite of the present disclosure has the effect of not forming pinholes and having a large and uniform grain size, thereby having high charge mobility.
In addition, the perovskite transistor comprising the perovskite composite of the present disclosure has the effect of effectively lowering the charge amount, thus having excellent characteristics.
In addition, the perovskite transistor of the present disclosure can provide an optoelectronic device (ex. transistor, solar cell, light-emitting diode, etc.) with high stability by comprising the perovskite composite.

## Description of Drawings

These drawings are for the purpose of describing exemplary embodiments of the present disclosure, and the technical idea of the present disclosure thus should not be construed as being limited to the accompanying drawings.

FIG. 1 is a schematic diagram of a perovskite transistor according to one embodiment of the present disclosure.
FIG. 2 is a flowchart showing a method for manufacturing a perovskite transistor according to one embodiment of the present disclosure.
FIG. 3 is a schematic diagram of a perovskite transistor manufactured according to Device Example 1.
FIG. 4a is a graph showing the XRD analysis results of Example 1-1, Comparative Examples 1-1 and 1-2, FIG. 4b is an image showing the GIWAXS data of Example 1-1, and FIG. 4c is an image showing the GIWAXS data of Comparative Example 1-1.
FIG. 5a is an image showing the SEM analysis results of Example 1-1, FIG. 5b is an image showing the SEM analysis results of Comparative Example 1-1, and FIG. 5c is an image showing the SEM analysis results of Comparative Example 1-2.
FIG. 6 is a PL spectroscopy graph of Example 1-1, Comparative Examples 1-1 and 1-2.
FIG. 7 is a TRPL spectroscopy graph of Example 1-1, Comparative Examples 1-1 and 1-2.

FIG. 8 shows the XPS analysis (O 1s) results of Examples 1-1 and 2-1 and Comparative Example 1-1.

FIG. 9a is a graph showing the XPS analysis (Sn 3d) results of Example 1-1, FIG. 9b is a graph showing the XPS analysis (Sn 3d) results of Example 2-1, FIG. 9c is a graph showing the XPS analysis (Sn 3d) results of Comparative Example 1-1, and FIG. 9d is a graph showing the XPS analysis (Sn 3d) results of Comparative Example 1-2.

FIG. 10 shows the current curves (output curves) of Device Example 1-1 and Device Comparative Example 1-2.

FIG. 11 shows the transfer curve of the Device Example 1-1.

FIG. 12a is a graph showing the transfer curve of the Device Examples 1-1 to 1-3 and the Device Comparative Example 1-1, and FIG. 12b is a graph showing the Hall effect of the Device Examples 1-1 to 1-3 and the Device Comparative Example 1-1.

FIG. 13a is a graph showing the transfer curve of the Device Examples 2-1 to 2-3 and the Device Comparative Example 1-1, and FIG. 13b is a graph showing the Hall effect of the Device Examples 2-1 to 2-3 and the Device Comparative Example 1-1.

**Best Mode**

Hereinafter, embodiments of the present disclosure will be described in detail with reference to the accompanying drawings so that those skilled in the art can easily carry out the present disclosure.

However, the following description does not limit the present disclosure to specific embodiments. In the following description of the present disclosure, the detailed description of related arts will be omitted if it is determined that the gist of the present disclosure may be blurred.

Terms used herein are used only to describe specific embodiments and are not intended to limit the present disclosure. The singular expression comprises the plural expression unless the context clearly indicates otherwise. It will be further understood that the terms "includes", "comprises", or "has" when used herein specify the presence of stated features, regions, integers, steps, operations, elements, and/or components, but do not preclude the presence or addition of one or more other features, regions, integers, steps, operations, elements, components, and/or combinations thereof.

Additionally, terms, such as "first", "second", etc. used herein, may be used to describe various components, but the components are not to be construed as being limited to the terms. These terms are used only for the purpose of distinguishing one component from another component. For Example, without departing from the scope of the present disclosure, a first component may be referred to as a second component, and a second component may be also referred to as a first component.

Additionally, when a component is referred to as being "formed", "positioned", "located" or "laminated" on another component, it may be formed directly or attached to the front or one surface on the surface of the other component, but it will be understood that intervening elements may be present therebetween.

Hereinafter, a perovskite composite comprising pseudo-halide additive, electronic device comprising same, and manufacturing method thereof will be described in detail. However, these are disclosed only for illustrative purposes and are not meant to limit the present disclosure, and the scope of the present disclosure is only defined by the appended claims.

According to one aspect of the present disclosure, a perovskite composite is provided, and the perovskite composite comprises: a tin (Sn) based perovskite; a first additive comprising a pseudo-halide anion; and a second additive comprising tin fluoride ($SnF_2$).

Specifically, the pseudo-halide anion of the first additive can play a role in reducing tin vacancies that occur during the production of a thin film by reacting more strongly with tin than the halide anion presents in the tin based perovskite, and the tin fluoride of the second additive can play a role in effectively passivating the Sn vacancies that occur during the formation of a thin film by containing Sn. Accordingly, when the first additive and the second additive are added together, the charge amount can be effectively controlled.

In addition, the pseudo-halide anion may be doped to the tin based perovskite.

In addition, the tin fluoride ($SnF_2$) may be doped to the tin based perovskite.

In addition, the pseudo-halide anion and the tin fluoride ($SnF_2$) may be co-doped to the tin based perovskite.

In addition, the pseudo-halide anion may comprise at least one selected from the group consisting of formate, acetate, carbonate, azide, cyanate, thiocyanate, selenocyanate, cyanide, tetrafluoroborate, hexafluorophosphate, and tetrahydrobiopterin, and preferably, it may comprise at least one selected from the group consisting of formate and acetate.

In addition, the tin based perovskite may be represented by Structural Formula 1 below, and may also comprise a composition of CsI excess doped-$FASnI_3$.

[Structural Formula 1] $$A_a(B_{(1-b)}C_b)_cSn(X_{(1-d)}Y_d)_e$$

In Structural Formula 1,

A is cesium (Cs),

B and C are different from each other and are each independently methylammonium (MA) or formamidinium (FA),

a is a real number in a range of $0 \leq a \leq 1$,

b is a real number in a range of $0 \leq b \leq 1$,

c is a real number in a range of $0 \leq c \leq 1$,

a and c are not 0 at the same time,

X and Y are different from each other and are each independently fluorine (F), chlorine (Cl), bromine (Br), or iodine (I),

d is a real number in a range of $0 \leq d \leq 1$, and

e is a real number in a range of $2.5 \leq d \leq 3.5$.

In addition, the perovskite composite may comprise 0.01 to 50 parts by mol, preferably 0.1 to 10 parts by mol, and more preferably 6 to 10 mol parts by mol of the first additive, based on 100 parts by mol of the total of the tin-based perovskite, the first additive and the second additive. When the first additive is less than 0.01 parts by mol, the charge reduction effect by comprising the first additive is insignificant, which is undesirable. When the first additive is more than 50 parts by mol, the stoichiometric coefficient of the perovskite deviates from the normal range, which is undesirable.

In addition, the perovskite composite may comprise 0.01 to 50 parts by mol, preferably 0.1 to 30 parts by mol, and more preferably 1 to 10 parts by mol of the second additive, based on 100 parts by mol of the total of the tin based perovskite, the first additive and the second additive. When the second additive is less than 0.01 parts by mol, the effect of lowering the hole concentration due to the inclusion of tin fluoride ($SnF_2$) is insignificant, which is not preferable. When the second additive is more than 50 parts by mol, phase separation due to tin trifluoride agglomeration occurs, which is not preferable.

In addition, the molar ratio (mol:mol) of the first additive and the second additive may be 10:90 to 90:10, preferably 30:70 to 70:30, and more preferably 30:70 to 40:60. When the molar ratio is less than 10:90 or more than 90:10, the effect of lowering the hole concentration is insignificant, which is not preferable.

According to another aspect of the present disclosure, an electronic device comprising the perovskite composite is provided, and the electronic device includes any one selected from the group consisting of a transistor, a solar cell, a light-emitting diode, a photodiode, and a photosensor.

According to another aspect of the present disclosure, a perovskite transistor **10** is provided, and the perovskite transistor comprises: a gate electrode **100;** an insulating layer 200 positioned on the gate electrode **100;** an active layer **300** positioned on the insulating layer **200** and comprising a perovskite composite; and a source electrode **400** and a drain electrode **500** positioned spaced apart from each other on the active layer **300,** wherein the perovskite composite comprises a tin (Sn) based perovskite; a first additive comprising a pseudo-halide anion; and a second additive comprising a tin fluoride ($SnF_2$).

In addition, the pseudo-halide anion may be doped to the tin based perovskite.

In addition, the tin fluoride may be doped to the tin based perovskite.

In addition, the pseudo-halide anion and the tin fluoride may be co-doped to the tin based perovskite.

In addition, the gate electrode **100** may comprise at least one selected from the group consisting of n-doped silicon (n-doped Si), p-doped silicon (p-doped Si), gold (Au), silver (Ag), platinum (Pt), titanium (Ti), aluminum (Al), tungsten (W), magnesium (Mg), calcium (Ca), ytterbium (Yb), chromium (Cr), nickel (Ni), molybdenum (Mo), gold oxide, platinum oxide, silver oxide, palladium oxide, iron oxide, graphene, carbon nanotube (CNT), silver nanowire (Ag NW), gallium indium eutectic, indium tin oxide, and poly (3,4-ethylenedioxythiophene) polystyrene sulfonate (PEDOT:PSS).

In addition, the source electrode **400** and the drain electrode 500 may each comprise at least one selected from the group consisting of gold (Au), silver (Ag), platinum (Pt), titanium (Ti), aluminum (Al), tungsten (W), magnesium (Mg), calcium (Ca), ytterbium (Yb), chromium (Cr), nickel (Ni), molybdenum (Mo), gold oxide, platinum oxide, silver oxide, palladium oxide, iron oxide, graphene, carbon nanotubes (CNT), silver nanowires (Ag nanowires (Ag NW), gallium indium eutectic, indium tin oxide, and poly(3,4-ethylenedioxythiophene) polystyrene sulfonate (PEDOT:PSS).

In addition, the insulating layer **200** may comprise at least one selected from the group consisting of silicon dioxide, glass, quartz, alumina, silicon carbide, magnesium oxide, polyethylene naphthalate (PEN), polyethylene terephthalate (PET), polystyrene (PS), polyimide (PI), polyvinyl chloride (PVC), polyvinyl pyrrolidone (PVP), polyethylene (PE), parylene, silicon oxide ($SiO_2$), germanium, polyvinyl alcohol (PVA), polymethyl methacrylate (PMMA), zirconium

oxide ($ZrO_2$), aluminum oxide ($AlO_2$), hafnium oxide ($HfO_2$), and bismuth antimony telluride (BST).

FIG. 2 is a flow chart showing a method for manufacturing a perovskite transistor according to one embodiment of the present disclosure.

Referring to FIG. 2, according to another aspect of the present disclosure, a method for manufacturing a perovskite composite is provided, and the method comprises: (a) mixing a first additive comprising a pseudo-halide anion and a second additive comprising a tin fluoride ($SnF_2$) into a first mixed solution comprising a compound represented by Structural Formula 2 below and a tin halide represented by Structural Formula 3 below, thus preparing a second mixed solution; (b) heating the second mixed solution to produce a perovskite precursor solution; and (c) drying and heat-treating the perovskite precursor solution, thus preparing a perovskite composite comprising a tin (Sn) based perovskite; a first additive comprising a pseudo-halide anion; and a second additive comprising a tin fluoride ($SnF_2$).

[Structural Formula 2] $A_a(B_{(1-b)}C_b)_c(X_{(1-d)}Y_d)_{e'}$

[Structural formula 3] $Sn(X_{(1-d)}Y_d)_{e''}$

In the structural formulas 2 and 3 above,

A is cesium (Cs),

B and C are different from each other and are each independently methylammonium (MA) or formamidinium (FA),

a is a real number in a range of $0 \leq a \leq 1$,

b is a real number in a range of $0 \leq b \leq 1$,

c is a real number in a range of $0 \leq c \leq 1$,

a and c are not 0 at the same time,

X and Y are different from each other and are each independently fluorine (F), chlorine (Cl), bromine (Br), or iodine (I),

d is a real number in a range of $0 \leq d \leq 1$,

$$e' + e'' = e,$$

and

e is a real number in a range of $2.5 \leq d \leq 3.5$.

In addition, the perovskite composite may comprise 0.01 to 50 parts by mol of the first additive, preferably 0.1 to 10 parts by mol, more preferably 1 to 8 parts by mol, based on 100 parts by mol of the tin based perovskite. When the first additive is less than 0.01 parts by mol, the charge reduction effect due to the inclusion of the first additive is insignificant, which is undesirable. When the first additive is more than 50 parts by mol, the stoichiometric coefficient of the perovskite deviates from the normal range, which is undesirable.

In addition, the perovskite composite may comprise 0.01 to 50 parts by mol of the second additive, preferably 0.1 to 30 parts by mol, more preferably 1 to 10 parts by mol, based on 100 parts by mol of the tin based perovskite. When the second additive is less than 0.01 parts by mol, the effect of lowering the hole concentration due to the inclusion of tin fluoride ($SnF_2$) is insignificant, which is not preferable. When the second additive is more than 50 parts by mol, phase separation occurs due to tin trifluoride agglomeration, which is not preferable.

In addition, the molar ratio (mol:mol) of the first additive and the second additive may be 10:90 to 90:10, preferably 30:70 to 70:30, and more preferably 30:70 to 40:60. When the molar ratio is less than 10:90 or more than 90:10, the effect of lowering the hole concentration is insignificant, which is not preferable.

In addition, the step (b) may be performed at a temperature in a range of 80 to 150°C, and preferably at a temperature in a range of 90 to 110°C. When the step (b) is carried out at a temperature of less than 80°C, the compounds comprised in the second mixed solution may not be mixed well, which may deteriorate the performance of the perovskite composite. When the step (b) is carried out at a temperature of more than 150°C, by-products may be formed, which is not preferable.

In addition, the heat treatment of the step (c) may be carried out at a temperature in a range of 100 to 150°C, and preferably at a temperature in a range of 120 to 140°C. When the heat treatment is carried out at a temperature of less than 100°C, the perovskite composite may not be formed well, which is not preferable. When the heat treatment is carried out at a temperature of 150°C, by-products may be formed, which is not preferable.

According to another aspect of the present disclosure, a method for manufacturing a perovskite transistor is provided, and the method comprises: (1) preparing a gate electrode/insulating layer laminate comprising a gate electrode and an insulating layer positioned on the gate electrode; (2) forming an active layer comprising a perovskite composite on the insulating layer; and (3) forming a source electrode and a drain electrode on the active layer, wherein the perovskite composite comprises a tin (Sn) based perovskite; a first additive comprising a pseudo-halide anion; and a second additive comprising a tin fluoride ($SnF_2$).

**Mode for Disclosure**

[Examples]

Hereinafter, the present disclosure will be described in more detail with Examples. However, these Examples are disclosed for illustrative purposes and the scope of the present disclosure is not limited thereby.

< Perovskite Composite Manufacturing >

Example 1: Use of formic acid + $SnF_2$

Example 1-1: Formate 6 mol: $SnF_2$ 10 mol

CsI, FAI, and $SnI_2$ were added to a co-solvent of N,N-Dimethylformamide (DMF) and Dimethylsulfoxide (DMSO) (DMF: DMSO = 4:1 (vol: vol)) to prepare a 0.4 M CsI solution, a 1 M FAI solution, and a 1 M $SnI_2$ solution, respectively. The 0.4 M CsI solution, the 1 M FAI solution, and the 1 M $SnI_2$ solution were mixed so that CsI, FAI, and $SnI_2$ were 0.078 M, 0.3 M, and 0.3 M, respectively, thus preparing a first mixed solution.

Tin fluoride and formic acid were added to the first mixed solution so that the molar ratio of tin based perovskite: formate ($HCOO^-$): tin fluoride ($SnF_2$) in the fabricated perovskite composite was 100 mol:6 mol:10 mol, thereby preparing a second mixed solution.

The second mixed solution was heated at room temperature to 100° C for 0.1 to 24 hours to prepare a precursor solution.

The precursor solution was dropped onto a $SiO_2$/Si substrate and spin-coated 1 to 5 times at a speed of 0.5 to 9 krpm (rotation per minute) for 1 to 120 seconds. Afterwards, a $Cs_{0.26}FASnI_{3.2}$ perovskite composite containing 6 parts by mol of formate and 10 parts by mol of $SnF_2$ based on 100 parts by mol of tin based perovskite was prepared by heat treatment at room temperature to 130°C for 1 to 30 minutes. Here, when 6 parts by mol of formate was added, 6 parts by mol of I was removed, thus preparing a perovskite composite represented by $Cs_{0.26}FASnI_{3.2}$.

Examples 1-2 and 1-3: formate 3 mol: $SnF_2$ 10 mol, formate 10 mol: $SnF_2$ 10 mol

In the Example 1-1, the second mixed solution were prepared by adding tin fluoride and formic acid to the first mixed solution so that the molar ratio of tin based perovskite:formate ($HCOO^-$):tin fluoride ($SnF_2$) in the finally prepared perovskite composite was 100 mol:6 mol:10 mol. But in Examples 1-2 and 1-3 the perovskite composites were prepared in the same manner as in Example 1-1, respectively, except that tin fluoride and formic acid were added to the first mixed solution so that the molar ratio was as described in Table 1 below when preparing the second mixed solution.

Example 2: Using acetic acid + $SnF_2$

Example 2-1: Acetate 6 mol: $SnF_2$ 10 mol

A perovskite composite $Cs_{0.26}FASnI_{3.2}$ containing tin based perovskite 100 mol : Acetate 6 mol : $SnF_2$ 10 mol was finally prepared in the same manner as Example 1-1 except that Cs acetate was used instead of formic acid. Here, when 6 parts by mol of acetate were added, 6 parts by mol of I were removed, thus resulting in a perovskite composite $Cs_{0.26}FASnI_{3.2}$.

Examples 2-2 and 2-3: acetate 3 mol:$SnF_2$ 10 mol, acetate 10 mol:$SnF_2$ 10 mol

In the Example 1-1, formic acid was used, and the second mixed solution were prepared by adding tin fluoride and formic acid to the first mixed solution so that the molar ratio of tin based perovskite:formate ($HCOO^-$):tin fluoride ($SnF_2$) in the finally prepared perovskite composite was 100 mol:6 mol:10 mol. But in Examples 2-2 and 2-3 the perovskite composites were prepared in the same manner as in Example 1-1, respectively, except that tin fluoride and Cs acetate were added to the first mixed solution so that the molar ratio was as described in Table 1 below when preparing the second mixed solution.

Comparative Example 1: Use of $SnF_2$

Comparative Example 1-1: $SnF_2$ 10 mol

A perovskite composite was prepared in the same manner as in Example 1-1, except that formic acid was not added when preparing the second mixed solution.

Comparative Example 1-2: $SnF_2$ 20 mol

In the Example 1-1, the second mixed solution were prepared by adding tin fluoride to the first mixed solution so that the molar ratio of tin fluoride ($SnF_2$) in the finally prepared perovskite composite was 10. But in Comparative Examples 1-2 the perovskite composites were prepared in the same manner as in Example 1-1, except that formic acid is not added and tin fluoride were added to the first mixed solution so that the molar ratio of tin fluoride ($SnF_2$) was 20 as described in Table 1 below when preparing the second mixed solution.

Comparative Example 2: Tin based perovskite without additives

CsI, FAI, and $SnI_2$ were added to a co-solvent of N,N-Dimethylformamide (DMF) and Dimethylsulfoxide (DMSO) (DMF:DMSO = 4:1 (vol:vol)) to prepare a 0.4 M CsI solution, a 1 M FAI solution, and a 1 M $SnI_2$ solution, respectively. The 0.4 M CsI solution, the 1 M FAI solution, and the 1 M $SnI_2$ solution were mixed so that CsI, FAI, and $SnI_2$ were 0.078 M, 0.3 M, and 0.3 M, respectively, thus preparing a first mixed solution.
The first mixed solution was heated at room temperature to 100°C for 0.1 to 24 hours to prepare a precursor solution.
The precursor solution was dropped onto a $SiO_2$/Si substrate and spin-coated 1 to 5 times at a speed of 0.5 to 9 krpm (rotations per minute) for 1 to 120 seconds. Thereafter, a tin based perovskite ($Cs_{0.26}FASnI_{3.26}$) thin film was prepared by heat treatment at room temperature to 130°C for 1 to 30 minutes.

[Table 1]

| Classification | Molar ratio | | | |
|---|---|---|---|---|
| | tin based perovskite (mol) | first additive | | second additive |
| | | formic acid (mol) | acetic acid (mol) | $SnF_2$ (mol) |
| Example 1-1 | 100 | 6 | - | 10 |
| Example 1-2 | 100 | 3 | - | 10 |
| Example 1-3 | 100 | 10 | - | 10 |
| Example 2-1 | 100 | - | 6 | 10 |
| Example 2-2 | 100 | - | 3 | 10 |
| Example 2-3 | 100 | - | 10 | 10 |
| Comparative Example 1-1 | 100 | - | - | 10 |
| Comparative Example 1-2 | 100 | - | - | 20 |
| Comparative Example 2 | 100 | - | - | - |

Transistor Manufacturing

Device Example 1

FIG. 1 is a schematic diagram of a perovskite transistor according to one embodiment of the present disclosure, and FIG. 2 is a flow chart showing a method for manufacturing a perovskite transistor according to one embodiment of the present disclosure, and FIG. 3 is a schematic diagram of a perovskite transistor manufactured according to Device Example 1.

The transistor of Device Example 1 was manufactured according to FIGs 1 to 3.

First, the precursor solution manufactured in Example 1 was dropped onto $SiO_2$ of a $Si^{++}/SiO_2$ substrate and spin-coated 1 to 5 times for 1 to 120 seconds at a speed of 0.5 to 9 krpm (rotations per minute). Thereafter, heat treatment was performed at room temperature to 130°C for 1 to 30 minutes to form an active layer comprising a perovskite composite.

Au electrodes were deposited on the active layer to form source and drain electrodes.

Device Example 2 and Device Comparative Example 1

FIG. 1 is a schematic diagram of a perovskite transistor according to one embodiment of the present disclosure, and FIG. 2 is a flowchart showing a method for manufacturing a perovskite transistor according to one embodiment of the present disclosure. Referring to FIGS. 1 and 2, transistors of Device Example 2 and Device Comparative Example 1 were manufactured.

Transistors were manufactured under the same conditions as Device Example 1, but the precursor solutions used were changed to manufacture transistors of Device Examples 2 to 4 and Device Comparative Examples 1 to 4, and the manufacturing conditions are described in Table 2 below.

[Table 2]

| Classification | Perovskite composite |
|---|---|
| Device Example 1-1 | Example 1-1 |
| Device Example 1-2 | Example 1-2 |
| Device Example 1-3 | Example 1-3 |
| Device Example 2-1 | Example 2-1 |
| Device Example 2-2 | Example 2-2 |
| Device Example 2-3 | Example 2-3 |
| Device Comparative Example 1-1 | Comparative Example 1-1 |
| Device Comparative Example 1-2 | Comparative Example 1-2 |

[Test Examples]

Test Example 1: Comparison of the effects when only $SnF_2$ is used and when the first additive + $SnF_2$ is used

FIG. 4a is a graph showing the XRD analysis results of Example 1-1, Comparative Examples 1-1, and 1-2.

According to FIG. 4a, the peak size of Example 1-1, where formate + $SnF_2$ are added, is larger than that of Comparative Example 1-2, where $SnF_2$ is added in excess (20 mol ratio) to the tin based perovskite, confirming that Example 1-1 has the best crystallinity.

Therefore, it can be seen that the crystallinity is improved more when the two additives are mixed and added, and that the crystallinity improvement is more effective than when only $SnF_2$ is added in excess.

FIG. 4b is an image showing the GIWAXS data of Example 1-1, and FIG. 4c is an image showing the GIWAXS data of Comparative Example 1-1.

According to FIGS. 4b and 4c, it can be confirmed that the crystallinity is excellent through the growth of crystals in an aligned direction due to the addition of a pseudo-halide additive.

FIG. 5a is an image showing the SEM analysis results of Example 1-1, FIG. 5b is an image showing the SEM analysis results of Comparative Example 1-1, and FIG. 5c is an image showing the SEM analysis results of Comparative Example 1-2.

According to FIGS. 5a to 5c, it can be confirmed that when a small amount of $SnF_2$ additive (10 mol ratio) is added, the grain size increases and charge transfer is advantageous, and a thin film without pinhole defects can be formed.

On the other hand, when only $SnF_2$ is added in excess, it can be confirmed that pinhole defects are formed in the thin film.

Specifically, when $SnF_2$ is added in excess to tin based perovskite ($Cs_{0.26}FASnI_{3.26}$), a phase separation occurs, many pinhole defects occur, and the size of the XRD peak is relatively small, whereas when formate and $SnF_2$ are added together, Sn vacancies, which are representative defects of tin based perovskite, are suppressed, and the grain size increases and the quality of the thin film improves, showing that the limitations of existing hole suppressors can be overcome.

Test Example 2: Confirmation of PL spectroscopy and TRPL spectroscopy analysis results

FIG. 6 is a Photoluminescence Spectroscopy (PL spectroscopy) graph of Example 1-1, Comparative Examples 1-1 and 1-2, and FIG. 7 is a Time-Resolved Photoluminescence Spectroscopy (TRPL spectroscopy) graph of Example 1-1, Comparative Examples 1-1 and 1-2.

According to FIGS. 6 and 7, it can be confirmed that the introduction of pseudo-halides is effective in defect control through the increase in PL intensity and the increase in carrier life time of TRPL spectroscopy data.

Test Example 3: Confirmation of XPS Analysis Results of Perovskite Composite

FIG. 8 shows the XPS analysis (O 1s) results of Examples 1-1 (with Formate), 2-1 (with Acetate) and Comparative Example 1-1 (pristine), FIG. 9a is a graph showing the XPS analysis (Sn 3d) results of Example 1-1 (10 mol $SnF_2$:6 mol formate), FIG. 9b is a graph showing the XPS analysis (Sn 3d) results of Example 2-1 (10 mol $SnF_2$:6 mol acetate), FIG. 9c is a graph showing the XPS analysis (Sn 3d) results of Comparative Example 1-1 (pristine), and FIG. 9d is a graph showing the XPS analysis (Sn 3d) results of Comparative Example 1-2 (20 mol $SnF_2$).

According to FIG. 8, it can be confirmed that pseudo-halides ($HCOO^-$ and $CH_3COO^-$, respectively) exist on the surface of the perovskite composite as the additives (formic acid and acetic acid) are added.

According to FIGS. 9a to 9d, it can be confirmed that the oxidation of tin (Sn) in the tin based perovskite is effectively suppressed as the additives (formic acid and acetic acid) are added.

In detail, tin does not form perovskite when it is $Sn^{4+}$, but forms perovskite when it is $Sn^{2+}$, and it is easy for $Sn^{2+}$ to be oxidized to $Sn^{4+}$, which causes vacancies in Sn to occur.

In FIGS. 9a to 9d, Comparative Example 1-1 (pristine) can be confirmed to have $Sn^{2+}$ and $Sn^{4+}$ in a 6:4 ratio, and Comparative Example 1-2 (20 mol $SnF_2$) with additional $SnF_2$ can be confirmed to have more $Sn^{2+}$ than Comparative Example 1-1, thereby preventing tin oxidation.

Meanwhile, Example 1-1 (10 mol $SnF_2$:6 mol formate) and Example 2-1 (10 mol $SnF_2$:6 mol acetate) can be confirmed to have $Sn^{2+}$ in a ratio exceeding 80%, thereby preventing tin oxidation better than Comparative Examples 1-1 and 1-2. This not only shows a more effective oxidation inhibition effect than the existing hole inhibitor, but also contributes to the improvement of device performance through the effect of effectively suppressing under-coordinated Sn that does not form bonds.

Test Example 4: Confirmation of Transistor Characteristics Using Perovskite Composite

FIG. 10 shows the current curves (output curves) of Device Example 1-1 and Device Comparative Example 1-2, and FIG. 11 shows the transfer curves of Device Example 1-1.

In detail, FIG. 10 shows the current ($I_{ds}$) flowing through the active layer according to the application of the drain voltage when the gate voltage ($V_G$) is set to -50 to 0 V, and FIG. 11 shows the current ($I_{ds}$) flowing through the active layer according to the application of the gate voltage ($V_G$) (in this case, the voltage between the source electrode and the drain electrode is -40 V ($V_{ds}$ = -40 V)).

According to FIGS. 10 and 11, it can be confirmed that the perovskite transistor manufactured according to the present disclosure shows typical P-type transistor characteristics. At this time, the mobility is about 70 to 80 $cm^2/Vs$, and it can be confirmed that the current blinking ratio has excellent characteristics of $10^8$ or more.

Test Example 5: Confirmation of transistor characteristics according to the amount of additives in perovskite composites

FIG. 12a shows the transition curves of Device Examples 1-1 to 1-3 and Device Comparative Example 1-1, and FIG. 12b shows the Hall effect of Device Examples 1-1 to 1-3 and Device Comparative Example 1-1.

According to FIGS. 12a and 12b, in the case of Device Comparative Example 1-1 (pristine) to which the first additive (formate) was not added, a very low on/off ratio was shown, and accordingly, it can be confirmed that on/off flickering did not occur.

In addition, in the case of Device Comparative Example 1-1 (FOR 0) to which no additive was added, it can be confirmed that it functions like a conductor as Sn vacancies are generated. This confirms that the charge amount of the tin based perovskite ($Cs_{0.26}FASnI_{3.26}$) is very high, so that the off-current does not occur.

On the other hand, when the first additive (formic acid) containing formate is used, the off-current gradually decreases, and it can be confirmed that the off-current operation of the transistor can be performed due to this.

In addition, it can be confirmed that the Sn vacancies are effectively controlled by the effect of the additive (formic acid) containing formate, so that the charge amount is controlled.

FIG. 13a shows the transition curves of Device Examples 2-1 to 2-3 and Device Comparative Example 1-1, and FIG. 13b shows the Hall effect of Device Examples 2-1 to 2-3 and Device Comparative Example 1-1.

According to FIGS. 13a and 13b, it can be confirmed that the same effect as when formic acid was used is achieved when cesium acetate(Cs acetate), which contains a pseudo-halide anion similar to formic acid, is used as an additive.

The scope of the present disclosure is defined by the appended claims rather than the detailed description presented above. All changes or modifications derived from the meaning and scope of the claims and the concept of equivalents should be construed to fall within the scope of the present disclosure.

## Claims

**1.** A perovskite composite comprising:

a tin (Sn) based perovskite;
a first additive comprising a pseudo-halide anion; and
a second additive comprising a tin fluoride ($SnF_2$).

**2.** The perovskite composite of claim 1, wherein the pseudo-halide anion is doped to the tin based perovskite.

**3.** The perovskite composite of claim 1, wherein the tin fluoride ($SnF_2$) is doped to the tin based perovskite.

**4.** The perovskite composite of claim 1, wherein the pseudo-halide anion and the tin fluoride are co-doped to the tin based perovskite.

**5.** The perovskite composite of claim 1, wherein the pseudo-halide anion comprises at least one selected from the group consisting of formate, acetate, carbonate, azide, cyanate, thiocyanate, selenocyanate, cyanide, tetrafluoroborate, hexafluorophosphate, and tetrahydrobiopterin.

**6.** The perovskite composite of claim 1, wherein the tin based perovskite is represented by Structural Formula 1 below:

[Structural Formula 1] $A_a(B_{(1-b)}C_b)_cSn(X_{(1-d)}Y_d)_e$

wherein in Structural Formula 1,

A is cesium (Cs),
B and C are different from each other and are each independently methylammonium (MA) or formamidinium (FA),
a is a real number in a range of $0 \leq a \leq 1$,
b is a real number in a range of $0 \leq b \leq 1$,
c is a real number in a range of $0 \leq c \leq 1$,
a and c are not both 0 at the same time,
X and Y are different from each other and are each independently fluorine (F), chlorine (Cl), bromine (Br), or iodine (I),
d is a real number in a range of $0 \leq d \leq 1$, and
e is a real number in a range of $2.5 \leq d \leq 3.5$.

**7.** The perovskite composite of claim 1, the perovskite composite comprises 0.01 to 50 parts by mole of the first additive based on 100 parts by mole of the tin based perovskite.

**8.** The perovskite composite of claim 1, the perovskite composite comprises 0.01 to 50 parts by mole of the second additive based on 100 parts by mole of the tin based perovskite.

**9.** The perovskite composite of claim 1, the molar ratio (mol:mol) of the first additive and the second additive is 10:90 to 90:10.

**10.** A perovskite transistor comprising:

a gate electrode;
an insulating layer positioned on the gate electrode;
an active layer positioned on the insulating layer and comprising a perovskite composite; and
a source electrode and a drain electrode positioned spaced apart from each other on the active layer,
wherein the perovskite composite comprises a tin (Sn) based perovskite; a first additive comprising a pseudo-halide anion; and a second additive comprising a tin fluoride ($SnF_2$).

**11.** The perovskite transistor of claim 10, wherein the pseudo-halide anion is doped to the tin based perovskite.

**12.** The perovskite transistor of claim 10, wherein the tin fluoride ($SnF_2$) is doped to the tin based perovskite.

**13.** The perovskite transistor of claim 10, wherein the gate electrode comprises at least one selected from the group consisting of n-doped silicon (n-doped Si), p-doped silicon (p-doped Si), gold (Au), silver (Ag), platinum (Pt), titanium (Ti), aluminum (Al), tungsten (W), magnesium (Mg), calcium (Ca), ytterbium (Yb), chromium (Cr), nickel (Ni), molybdenum (Mo), gold oxide, platinum oxide, silver oxide, palladium oxide, iron oxide, graphene, carbon nanotube (CNT), silver nanowire (Ag NW), gallium indium eutectic, indium tin oxide, and poly (3, 4-ethylenedioxythiophene) polystyrene sulfonate (PEDOT:PSS) and
the source electrode and the drain electrode each comprises at least one selected from the group consisting of gold (Au), silver (Ag), platinum (Pt), titanium (Ti), aluminum (Al), tungsten (W), magnesium (Mg), calcium (Ca), ytterbium (Yb), chromium (Cr), nickel (Ni), molybdenum (Mo), gold oxide, platinum oxide, silver oxide, palladium oxide, iron oxide, graphene, carbon nanotubes (CNT), silver nanowires (Ag nanowires (Ag NW), gallium indium eutectic, indium tin oxide, and poly(3,4-ethylenedioxythiophene) polystyrene sulfonate (PEDOT:PSS).

**14.** The perovskite transistor of claim 10, wherein the insulating layer comprises at least one selected from the group consisting of silicon dioxide, glass, quartz, alumina, silicon carbide, magnesium oxide, polyethylene naphthalate (PEN), polyethylene terephthalate (PET), polystyrene (PS), polyimide (PI), polyvinyl chloride (PVC), polyvinyl pyrrolidone (PVP), polyethylene (PE), parylene, silicon oxide ($SiO_2$), germanium, polyvinyl alcohol (PVA), polymethyl methacrylate (PMMA), zirconium oxide ($ZrO_2$), aluminum oxide ($AlO_2$), hafnium oxide ($HfO_2$), and bismuth antimony telluride (BST).

**15.** A method for manufacturing a perovskite composite, the method comprising:

(a) mixing a first additive comprising a pseudo-halide anion and a second additive comprising a tin fluoride ($SnF_2$) into a first mixed solution comprising a compound represented by Structural Formula 2 below and a tin halide represented by Structural Formula 3 below, thus preparing a second mixed solution;
(b) heating the second mixed solution, thus preparing a perovskite precursor solution; and
(c) drying and heat-treating the perovskite precursor solution, thus preparing a perovskite composite comprising a tin (Sn) based perovskite; a first additive comprising a pseudo-halide anion; and a second additive comprising a tin fluoride ($SnF_2$):

[Structural formula 2] $A_a(B_{(1-b)}C_b)_c(X_{(1-d)}Y_d)_{e'}$

[Structural formula 3] $Sn(X_{(1-d)}Y_d)_{e''}$

wherein in Structural Formulas 2 and 3 above,

A is cesium (Cs),
B and C are different from each other and are each independently methylammonium (MA) or formamidinium (FA),
a is a real number in a range of $0 \le a \le 1$,
b is a real number in a range of $0 \le b \le 1$,
c is a real number of in a range of $0 \le c \le 1$,
a and c are not both 0 at the same time,
X and Y are different from each other and are each independently fluorine (F), chlorine (Cl), bromine (Br), or iodine (I),
d is a real number in a range of 0≤d≤1,
e' + e" = e, and
e is a real number in a range of 2.5≤d≤3.5.

**16.** The method of claim 15, wherein the perovskite composite comprises 0.01 to 50 parts by mole of the first additive based on 100 parts by mole of the tin based perovskite.

**17.** The method of claim 15, wherein the perovskite composite comprises 0.01 to 50 parts by mole of the second additive based on 100 parts by mole of the tin based perovskite.

**18.** The method of claim 15, wherein the molar ratio (mol:mol) of the first additive and the second additive is 10:90 to 90:10.

**19.** The method of claim 15, wherein the step (b) is carried out at a temperature in a range of 80 to 150° C.

**20.** The method of claim 15, wherein the heat treatment of the step (c) is carried out at a temperature in a range of 100 to 150° C.

FIG. 1

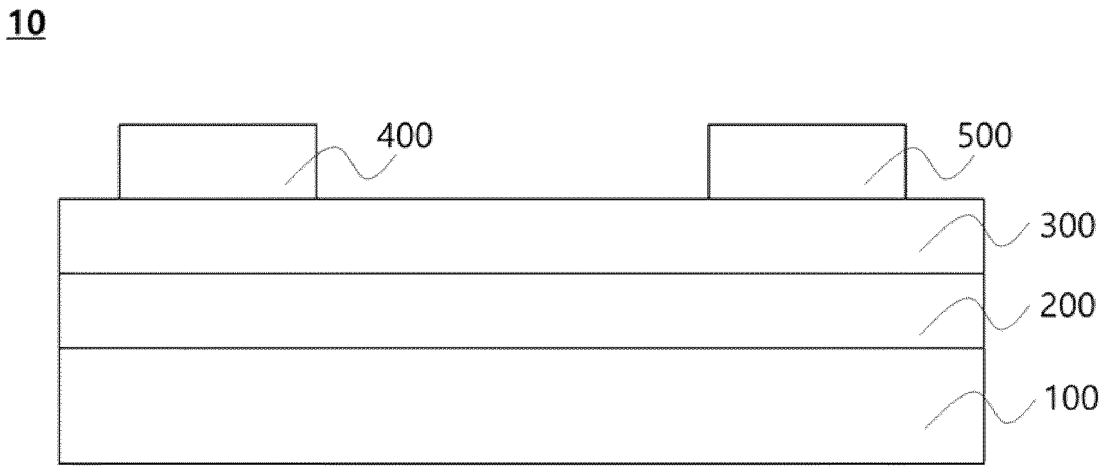

FIG. 2

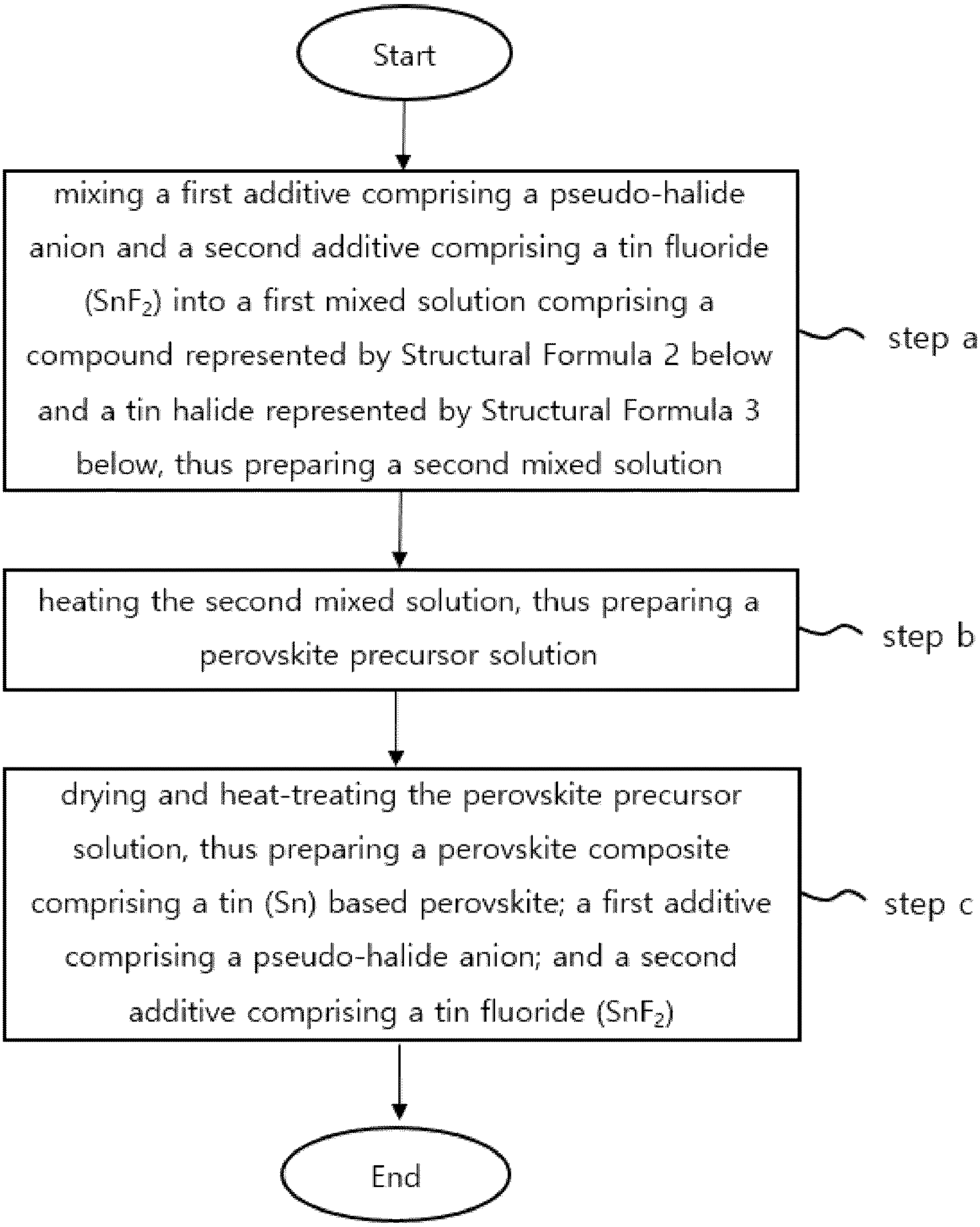
Start
mixing a first additive comprising a pseudo-halide anion and a second additive comprising a tin fluoride ($SnF_2$) into a first mixed solution comprising a compound represented by Structural Formula 2 below and a tin halide represented by Structural Formula 3 below, thus preparing a second mixed solution
step a
heating the second mixed solution, thus preparing a perovskite precursor solution
step b
drying and heat-treating the perovskite precursor solution, thus preparing a perovskite composite comprising a tin (Sn) based perovskite; a first additive comprising a pseudo-halide anion; and a second additive comprising a tin fluoride ($SnF_2$)
step c
End

FIG. 3

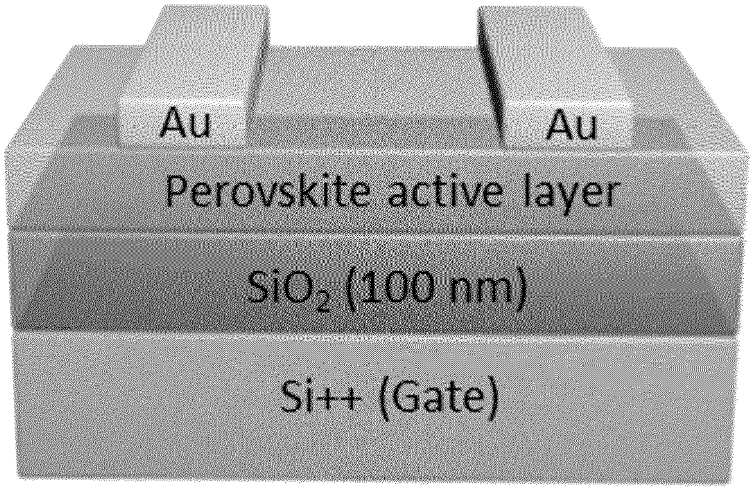
Au
Au
Perovskite active layer
SiO2 (100 nm)
Si++ (Gate)

FIG. 4a

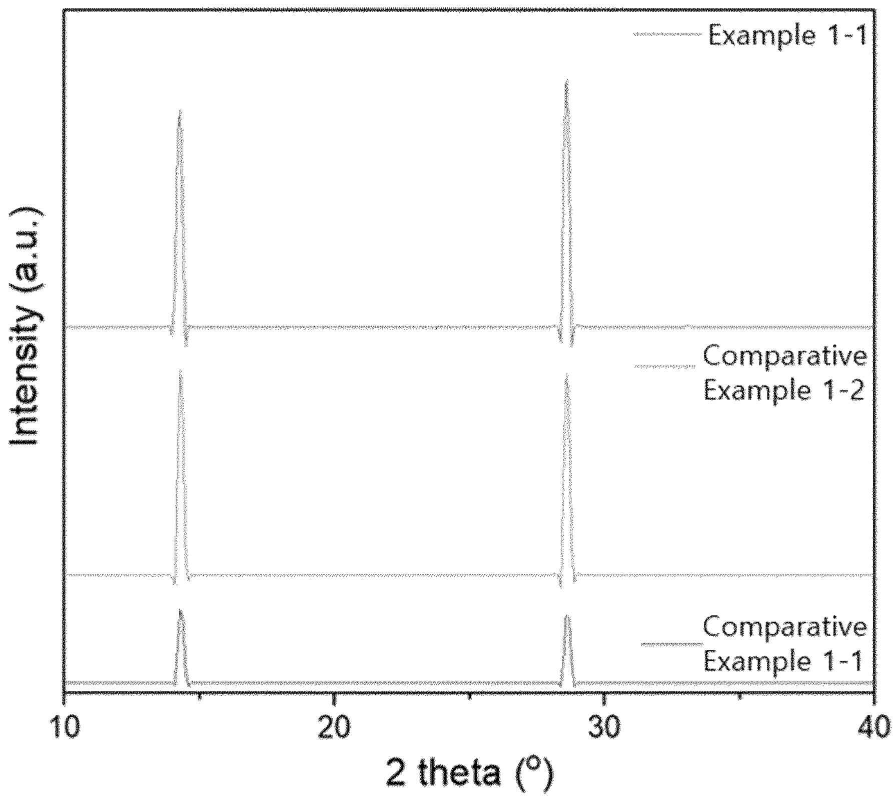
Example 1-1
Comparative Example 1-2
Comparative Example 1-1
Intensity (a.u.)
10
20
30
40
2 theta (°)

FIG. 4b

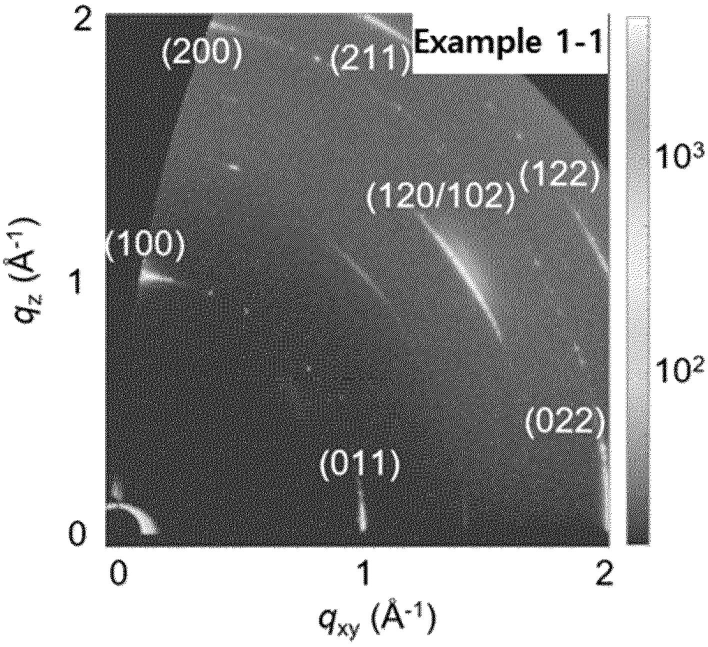
Example 1-1
(200)
(211)
(100)
(120/102)
(122)
(011)
(022)
$q_z$ (Å$^{-1}$)
$q_{xy}$ (Å$^{-1}$)
0
1
2
$10^3$
$10^2$

FIG. 4c

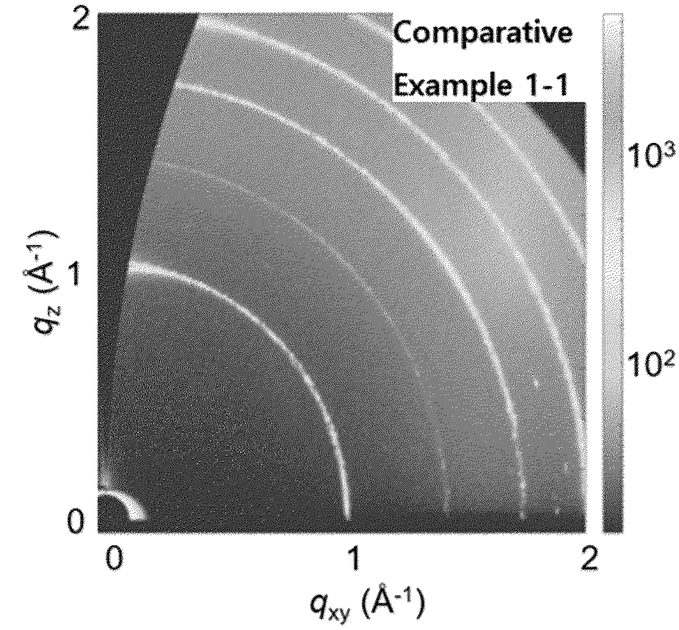
Comparative Example 1-1
$q_z$ (Å$^{-1}$)
$q_{xy}$ (Å$^{-1}$)
0
1
2
$10^3$
$10^2$

FIG. 5a

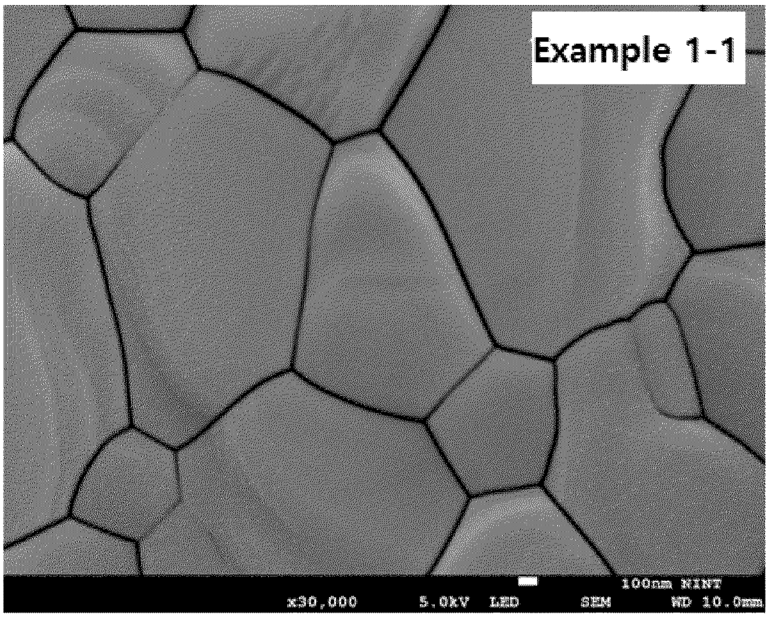
Example 1-1
100nm NINT
x30,000 5.0kV LED SEM WD 10.0mm

FIG. 5b

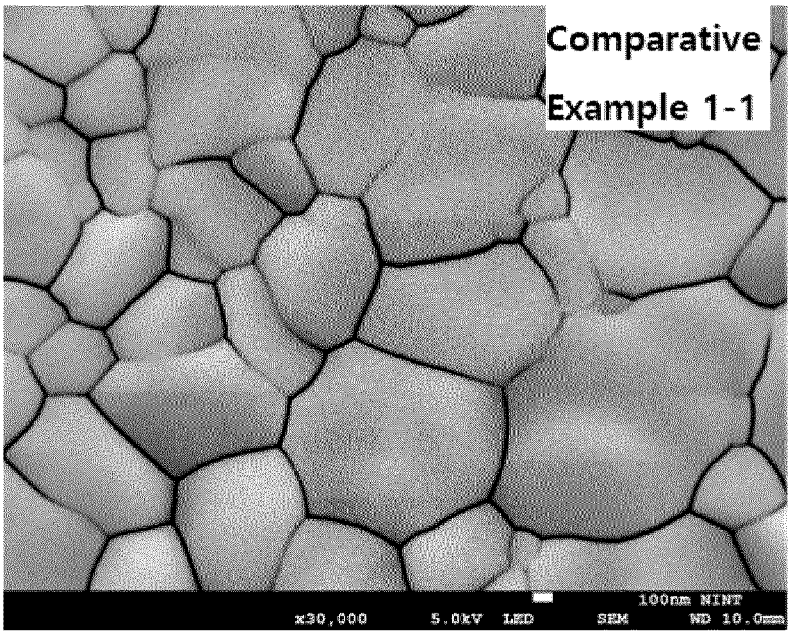
Comparative Example 1-1
100nm NINT
x30,000 5.0kV LED SEM WD 10.0mm

FIG. 5c

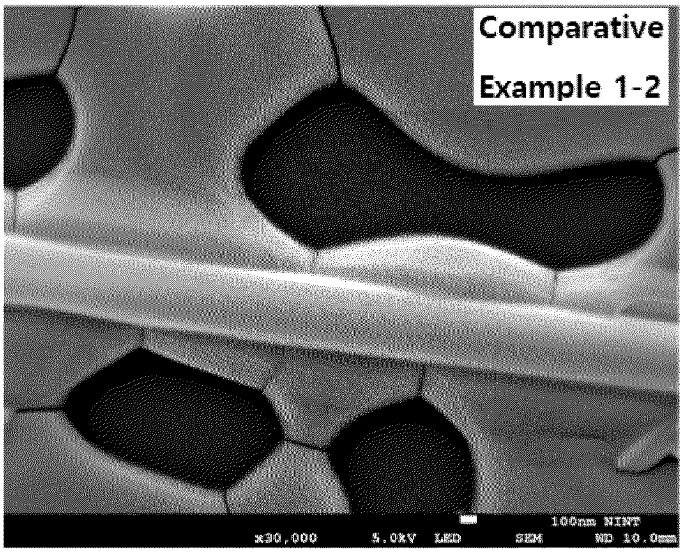
Comparative
Example 1-2
100nm NINT
x30,000 5.0kV LED SEM WD 10.0mm

FIG. 6

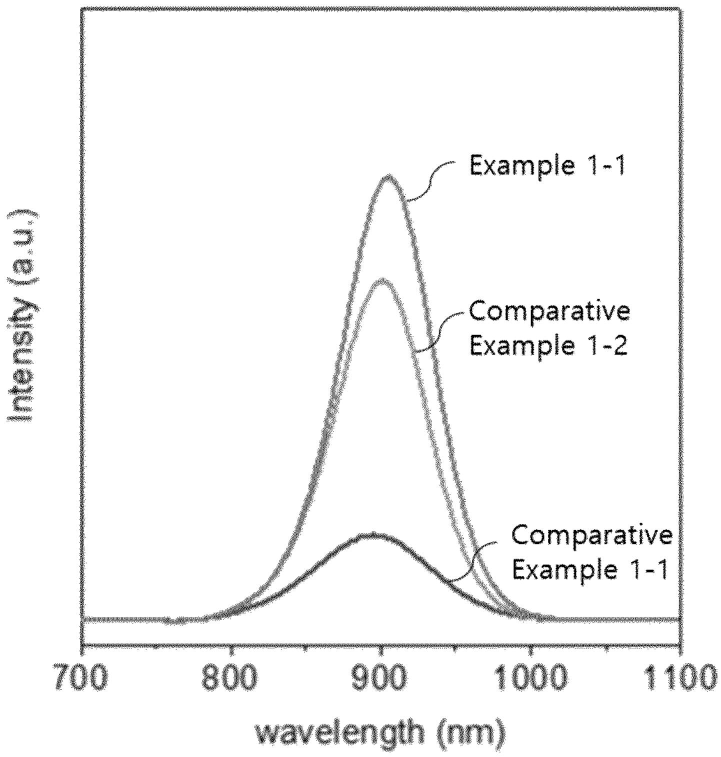
Example 1-1
Comparative
Example 1-2
Comparative
Example 1-1
Intensity (a.u.)
700
800
900
1000
1100
wavelength (nm)

FIG. 7

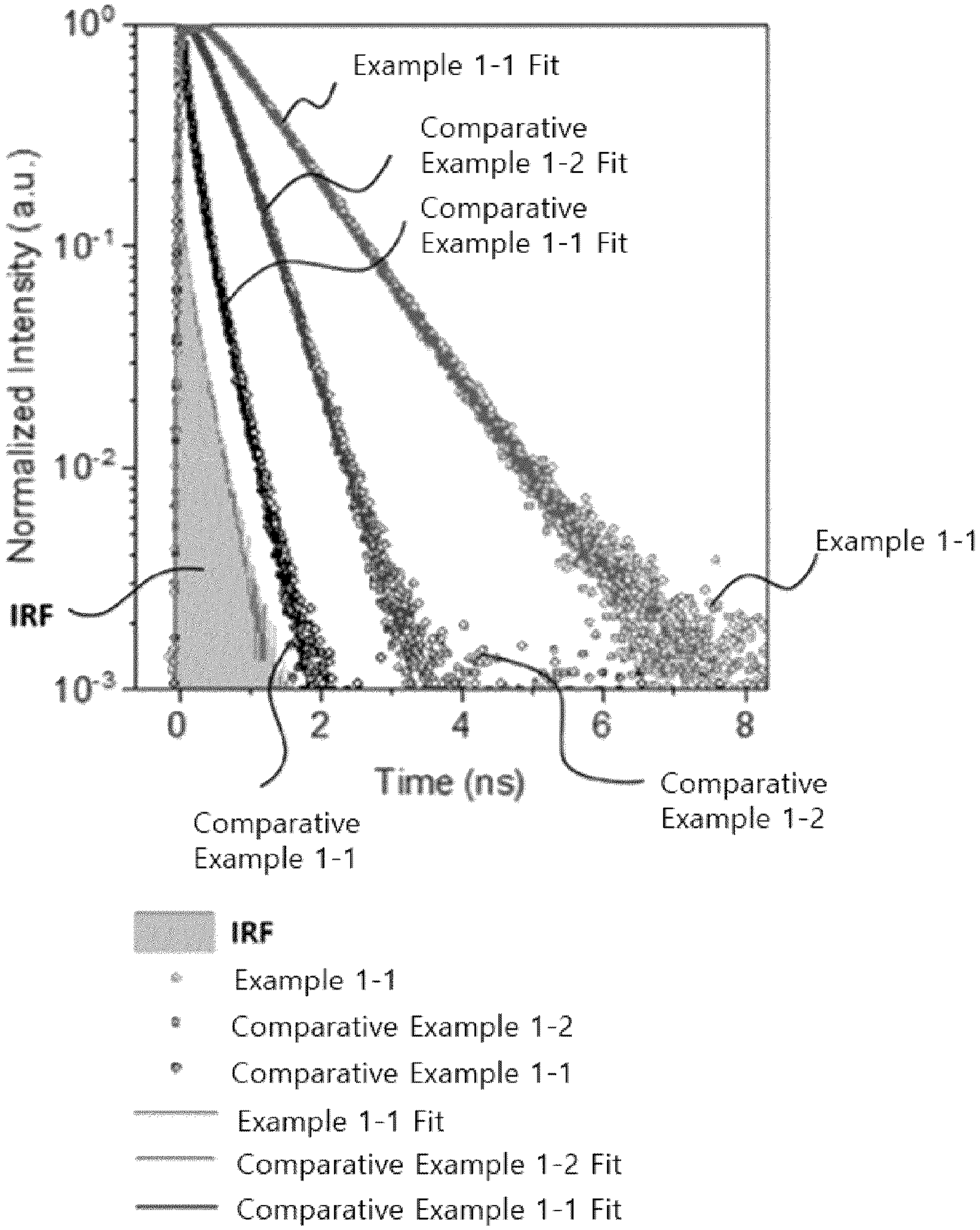

Example 1-1 Fit
Comparative Example 1-2 Fit
Comparative Example 1-1 Fit
Normalized Intensity (a.u.)
$10^0$
$10^{-1}$
$10^{-2}$
$10^{-3}$
IRF
Example 1-1
0
2
4
6
8
Time (ns)
Comparative Example 1-2
Comparative Example 1-1
IRF
Example 1-1
Comparative Example 1-2
Comparative Example 1-1
Example 1-1 Fit
Comparative Example 1-2 Fit
Comparative Example 1-1 Fit

FIG. 8

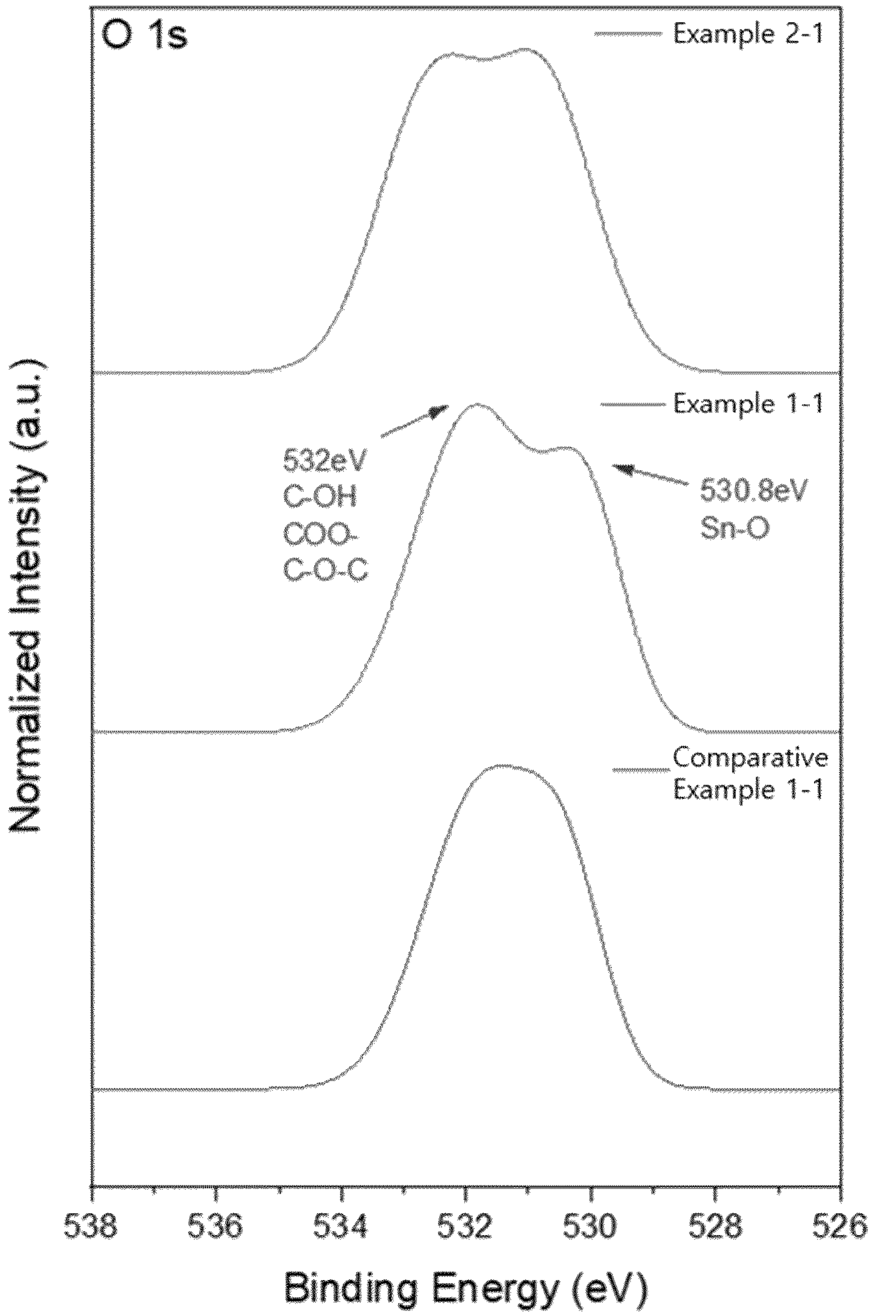
O 1s
Example 2-1
Example 1-1
532eV
C-OH
COO-
C-O-C
530.8eV
Sn-O
Comparative Example 1-1
Normalized Intensity (a.u.)
538
536
534
532
530
528
526
Binding Energy (eV)

FIG. 9a

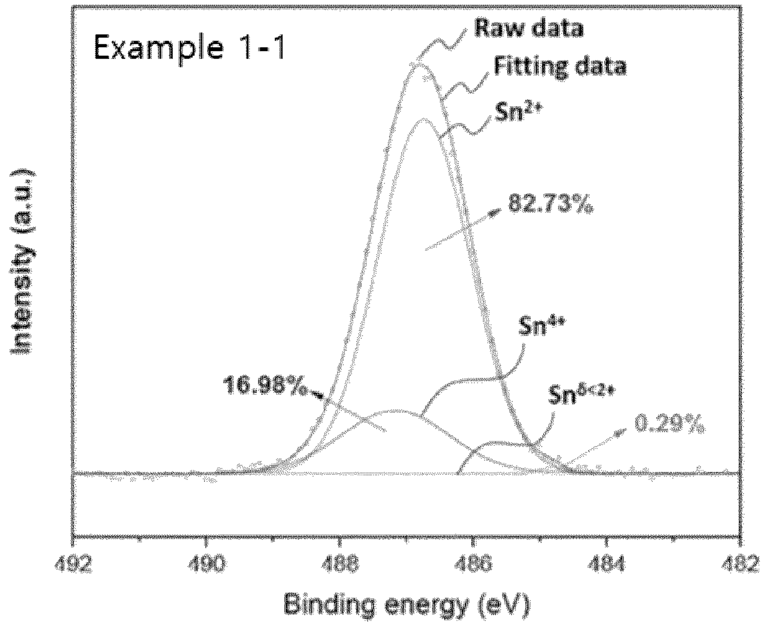
Example 1-1
Raw data
Fitting data
$Sn^{2+}$
82.73%
$Sn^{4+}$
16.98%
$Sn^{\delta<2+}$
0.29%
Intensity (a.u.)
492
490
488
486
484
482
Binding energy (eV)

FIG. 9b

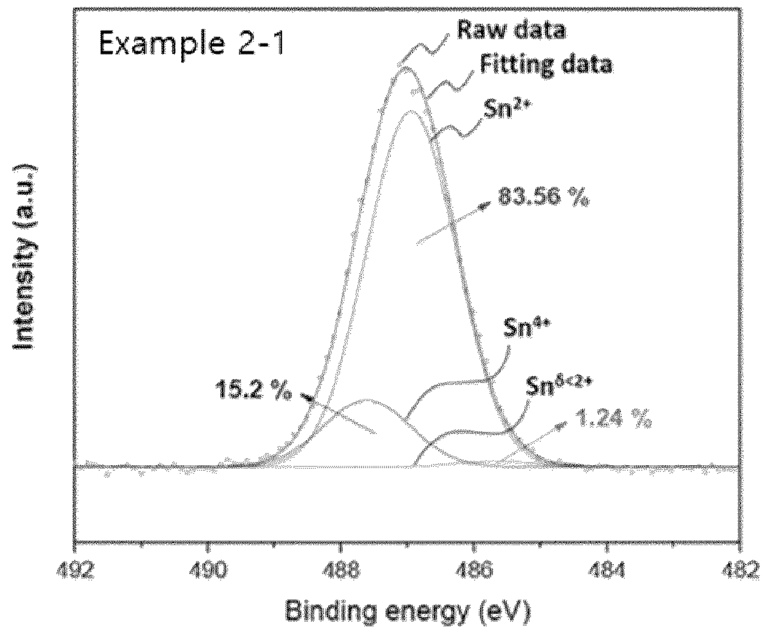
Example 2-1
Raw data
Fitting data
$Sn^{2+}$
83.56 %
$Sn^{4+}$
15.2 %
$Sn^{\delta<2+}$
1.24 %
Intensity (a.u.)
492
490
488
486
484
482
Binding energy (eV)

FIG. 9c

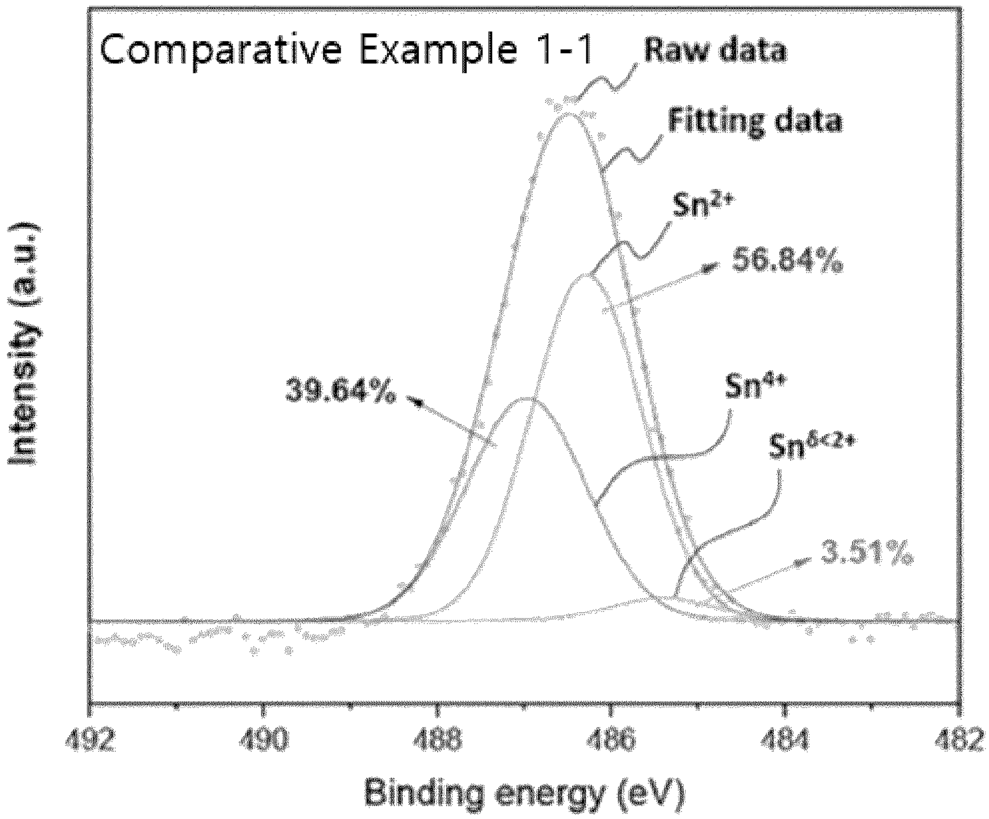
Comparative Example 1-1
Raw data
Fitting data
Sn2+
56.84%
39.64%
Sn4+
Snδ<2+
3.51%
Intensity (a.u.)
492
490
488
486
484
482
Binding energy (eV)

FIG. 9d

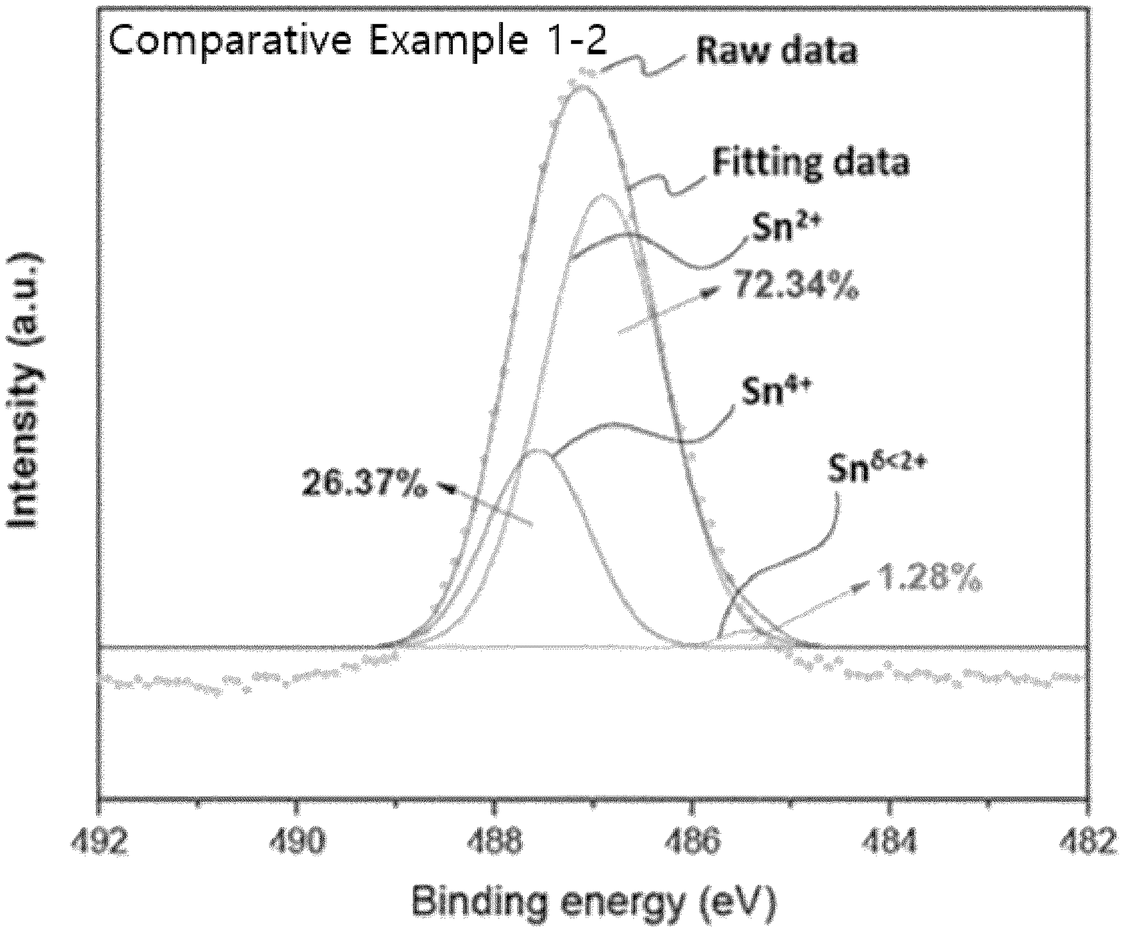
Comparative Example 1-2
Raw data
Fitting data
$Sn^{2+}$
72.34%
$Sn^{4+}$
26.37%
$Sn^{\delta<2+}$
1.28%
Intensity (a.u.)
492
490
488
486
484
482
Binding energy (eV)

FIG. 10

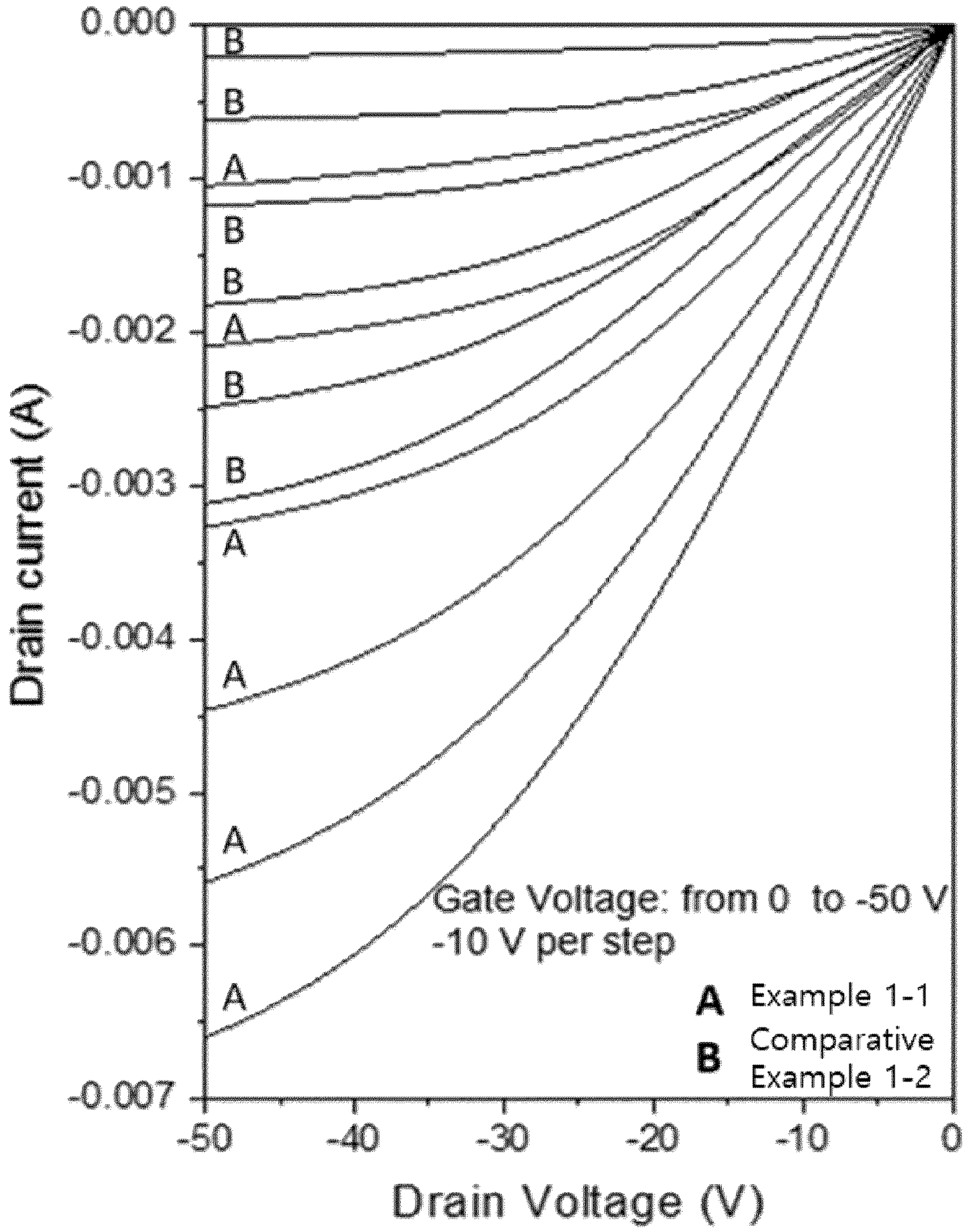
0.000
-0.001
-0.002
-0.003
-0.004
-0.005
-0.006
-0.007
Drain current (A)
-50
-40
-30
-20
-10
0
Drain Voltage (V)
B
B
A
B
B
A
B
B
A
A
A
A
Gate Voltage: from 0 to -50 V
-10 V per step
A Example 1-1
B Comparative Example 1-2

FIG. 11

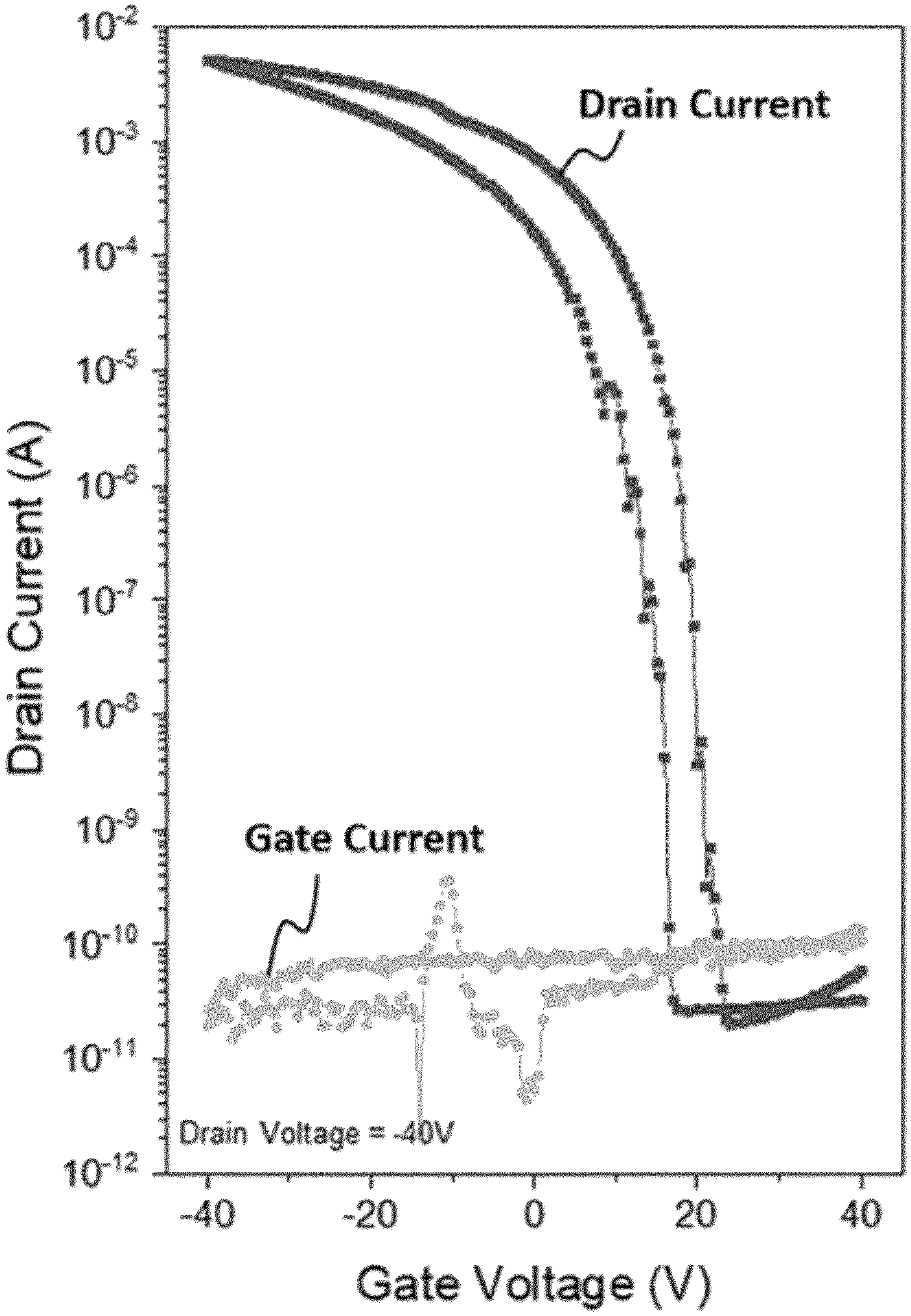
Drain Current
Gate Current
Drain Voltage = -40V
Drain Current (A)
Gate Voltage (V)
$10^{-2}$
$10^{-3}$
$10^{-4}$
$10^{-5}$
$10^{-6}$
$10^{-7}$
$10^{-8}$
$10^{-9}$
$10^{-10}$
$10^{-11}$
$10^{-12}$
-40
-20
0
20
40

FIG. 12a

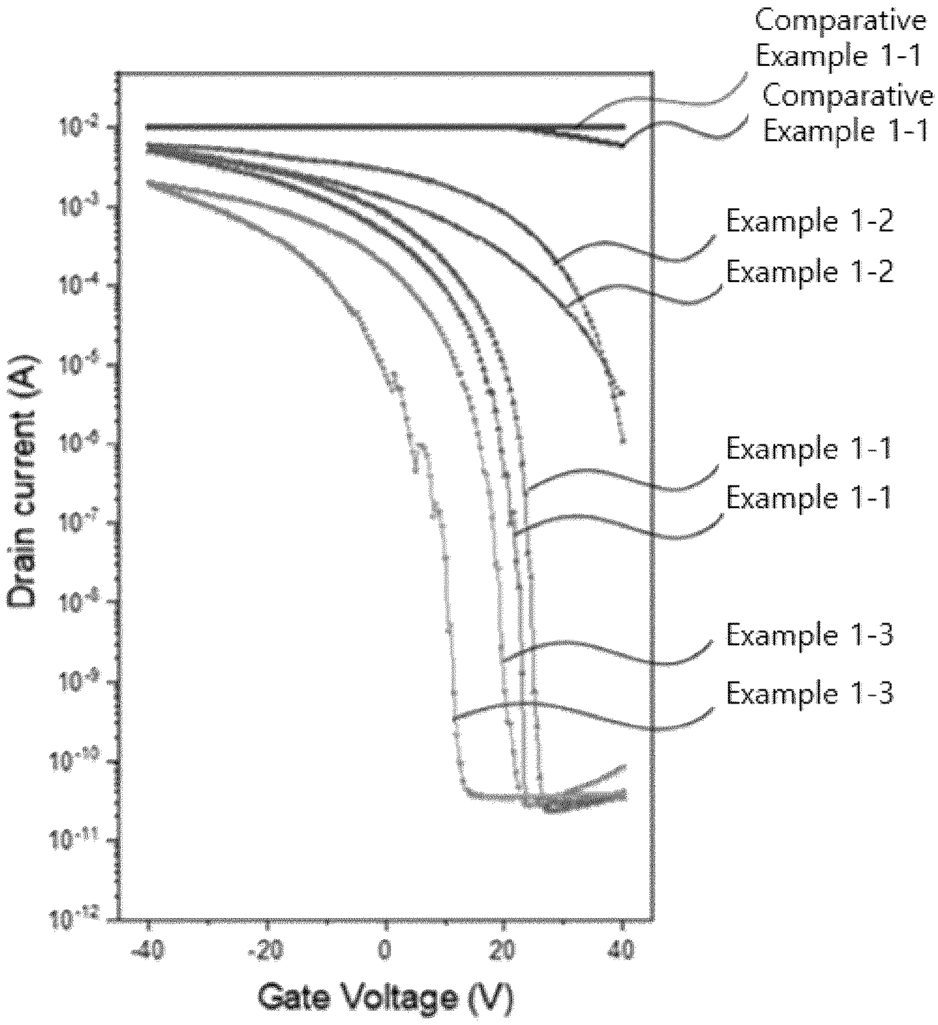
Comparative
Example 1-1
Comparative
Example 1-1
Example 1-2
Example 1-2
Example 1-1
Example 1-1
Example 1-3
Example 1-3
Drain current (A)
Gate Voltage (V)
-40
-20
0
20
40

FIG. 12b

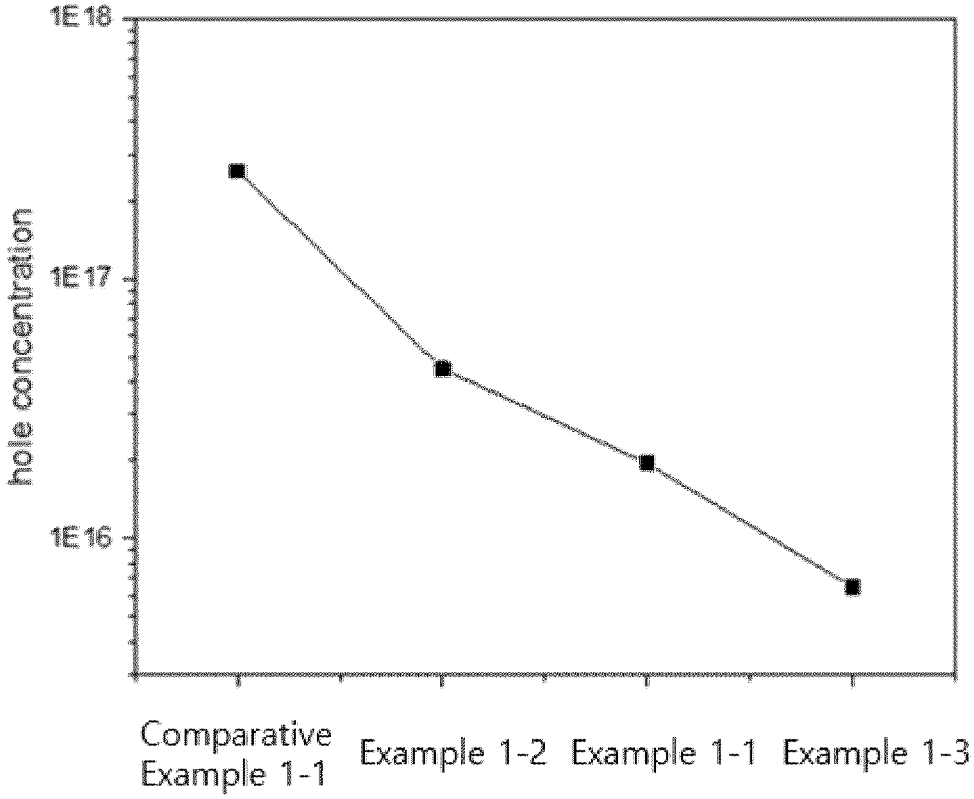
1E18
1E17
1E16
hole concentration
Comparative Example 1-1
Example 1-2
Example 1-1
Example 1-3

FIG. 13a

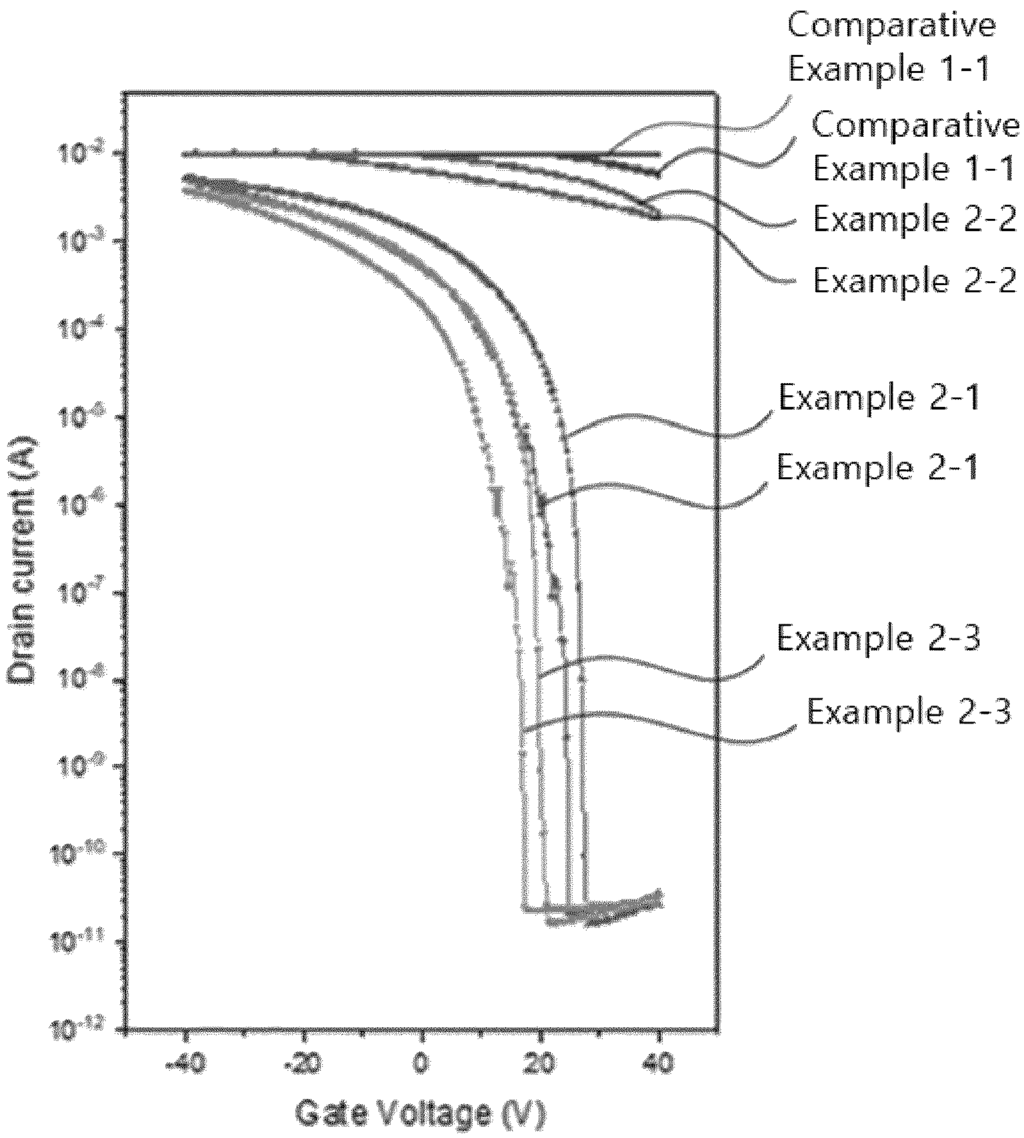
Comparative
Example 1-1
Comparative
Example 1-1
Example 2-2
Example 2-2
Example 2-1
Example 2-1
Example 2-3
Example 2-3
Drain current (A)
Gate Voltage (V)
-40
-20
0
20
40

FIG. 13b

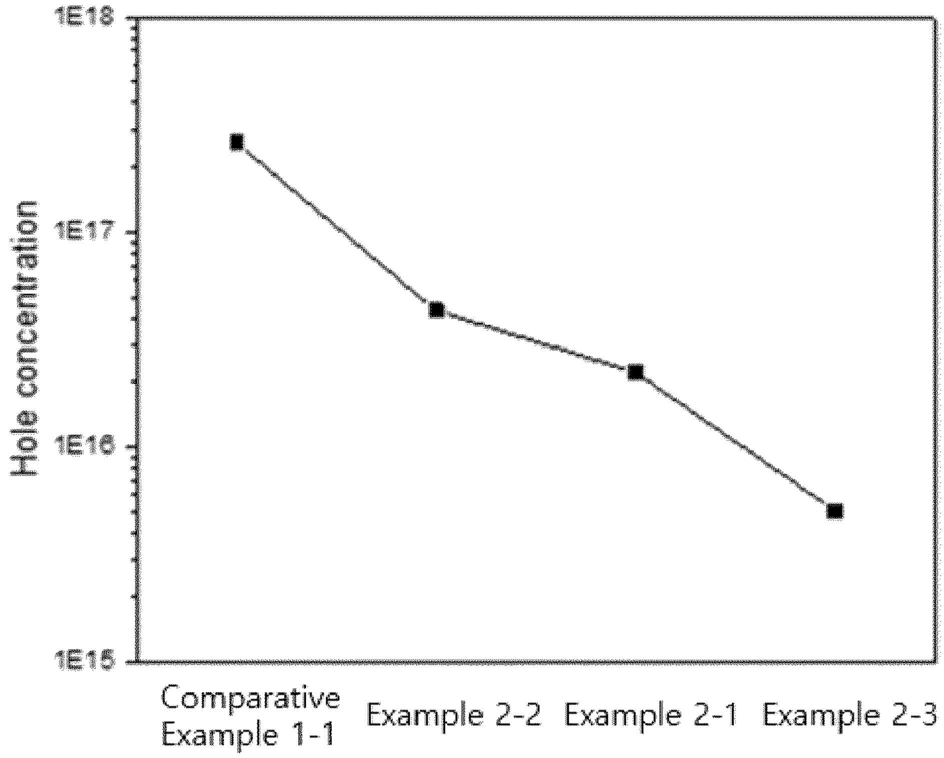
1E18
1E17
1E16
1E15
Hole concentration
Comparative Example 1-1
Example 2-2
Example 2-1
Example 2-3

**INTERNATIONAL SEARCH REPORT**

International application No.
**PCT/KR2024/002777**

**A. CLASSIFICATION OF SUBJECT MATTER**

**H10K 85/50**(2023.01)i; **H10K 10/46**(2023.01)i; **H10K 71/60**(2023.01)i; **H10K 71/12**(2023.01)i

According to International Patent Classification (IPC) or to both national classification and IPC

**B. FIELDS SEARCHED**

Minimum documentation searched (classification system followed by classification symbols)

H10K 85/50(2023.01); H01L 27/32(2006.01); H01L 51/00(2006.01); H01L 51/42(2006.01); H01L 51/44(2006.01); H01L 51/48(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 주석(tin), 페로브스카이트(perovskite), 준할라이드(pseudohalide), 플루오라이드(fluoride), 도핑(doping), 트랜지스터(transistor), 게이트 전극(gate electrode), 가열(heating)

**C. DOCUMENTS CONSIDERED TO BE RELEVANT**

| Category* | Citation of document, with indication, where appropriate, of the relevant passages | Relevant to claim No. |
|---|---|---|
| Y | KHADKA, Dhruba B. et al. Pseudohalide functional additives in tin halide perovskite for efficient and stable Pb-free perovskite solar cells. ACS Applied Energy Materials. 2021, vol. 4, pp. 12819-12826 (publication: 11 November 2021).<br>See abstract; page 12820, left column, lines 22-35 and right column, lines 2-24 and page 12824, left column, lines 52-62; and figure 1. | 1-20 |
| Y | GUPTA, Satyajit et al. How SnF2 impacts the material properties of lead-free tin perovskites. The Journal of Physical Chemistry C. 2018, vol. 122, pp. 13926-13936 (publication: 08 April 2018).<br>See abstract; and page 13927, left column, lines 8-16 and page 13928, right column, line 35 - page 13929, left column, line 48. | 1-20 |
| Y | KR 10-2022-0134824 A (SAMSUNG DISPLAY CO., LTD. et al.) 06 October 2022 (2022-10-06)<br>See paragraphs [0059]-[0063] and [0078]; and figures 1 and 2. | 10-14 |
| A | KR 10-2020-0096305 A (OXFORD UNIVERSITY INNOVATION LIMITED) 11 August 2020 (2020-08-11)<br>See claims 1-10. | 1-20 |

☑ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **10 June 2024** | **10 June 2024** |
| Name and mailing address of the ISA/KR<br>**Korean Intellectual Property Office**<br>**Government Complex-Daejeon Building 4, 189 Cheongsa-ro, Seo-gu, Daejeon 35208**<br>Facsimile No. **+82-42-481-8578** | Authorized officer<br><br>Telephone No. |

Form PCT/ISA/210 (second sheet) (July 2022)

**INTERNATIONAL SEARCH REPORT**

International application No.
**PCT/KR2024/002777**

**C. DOCUMENTS CONSIDERED TO BE RELEVANT**

| Category* | Citation of document, with indication, where appropriate, of the relevant passages | Relevant to claim No. |
|---|---|---|
| A | WO 2019-182058 A1 (KYOTO UNIVERSITY) 26 September 2019 (2019-09-26)<br>See claims 1-14. | 1-20 |

**INTERNATIONAL SEARCH REPORT**
**Information on patent family members**

International application No.
**PCT/KR2024/002777**

| Patent document cited in search report | Publication date (day/month/year) | Patent family member(s) | Publication date (day/month/year) |
|---|---|---|---|
| KR 10-2022-0134824 A | 06 October 2022 | CN 115132924 A | 30 September 2022 |
| | | US 2022-0310948 A1 | 29 September 2022 |
| KR 10-2020-0096305 A | 11 August 2020 | AU 2013-261254 A1 | 21 November 2013 |
| | | AU 2016-201773 A1 | 14 April 2016 |
| | | AU 2017-268594 A1 | 21 December 2017 |
| | | BR 112014028704 A2 | 09 August 2016 |
| | | CN 104662625 A | 27 May 2015 |
| | | CN 107964024 A | 27 April 2018 |
| | | CN 107973817 A | 01 May 2018 |
| | | CN 108269922 A | 10 July 2018 |
| | | CN 110372744 A | 25 October 2019 |
| | | CN 110452261 A | 15 November 2019 |
| | | CY 1117578 T1 | 26 April 2017 |
| | | CY 1123866 T1 | 27 May 2022 |
| | | DK 2850626 T3 | 09 May 2016 |
| | | DK 3336866 T3 | 25 January 2021 |
| | | EP 2850626 A1 | 25 March 2015 |
| | | EP 3024005 A1 | 25 May 2016 |
| | | EP 3336866 A1 | 20 June 2018 |
| | | ES 2565673 T3 | 06 April 2016 |
| | | ES 2853476 T3 | 16 September 2021 |
| | | HR P20160559 T1 | 17 June 2016 |
| | | HR P20210297 T1 | 16 April 2021 |
| | | JP 2015-517736 A | 22 June 2015 |
| | | JP 2017-193576 A | 26 October 2017 |
| | | JP 2019-149564 A | 05 September 2019 |
| | | JP 2022-140595 A | 26 September 2022 |
| | | JP 6182597 B2 | 16 August 2017 |
| | | JP 6517884 B2 | 22 May 2019 |
| | | JP 7446633 B2 | 11 March 2024 |
| | | KR 10-2015-0011002 A | 29 January 2015 |
| | | KR 10-2017-0060184 A | 31 May 2017 |
| | | KR 10-2017-0141272 A | 22 December 2017 |
| | | KR 10-2020-0111283 A | 28 September 2020 |
| | | KR 10-2022-0013015 A | 04 February 2022 |
| | | KR 10-2022-0062685 A | 17 May 2022 |
| | | KR 10-20220062685 A | 17 May 2022 |
| | | KR 10-2023-0149852 A | 27 October 2023 |
| | | KR 10-2282612 B1 | 28 July 2021 |
| | | KR 10-2354324 B1 | 08 February 2022 |
| | | KR 10-2354816 B1 | 24 January 2022 |
| | | PL 2850626 T3 | 30 September 2016 |
| | | PL 3336866 T3 | 28 June 2021 |
| | | PT 3336866 T | 05 January 2021 |
| | | US 11038132 B2 | 15 June 2021 |
| | | US 11258024 B2 | 22 February 2022 |
| | | US 2015-0136232 A1 | 21 May 2015 |
| | | US 2018-0083213 A1 | 22 March 2018 |
| | | US 2022-0231243 A1 | 21 July 2022 |
| | | US 2022-0263037 A1 | 18 August 2022 |

Form PCT/ISA/210 (patent family annex) (July 2022)

**INTERNATIONAL SEARCH REPORT**
**Information on patent family members**

International application No.
**PCT/KR2024/002777**

| Patent document cited in search report | Publication date (day/month/year) | Patent family member(s) | Publication date (day/month/year) |
|---|---|---|---|
| | | WO 2013-171517 A1 | 21 November 2013 |
| | | ZA 201408425 B | 26 May 2021 |
| WO 2019-182058 A1 | 26 September 2019 | CN 112106219 A | 18 December 2020 |
| | | EP 3770984 A1 | 27 January 2021 |
| | | JP 7389018 B2 | 29 November 2023 |
| | | US 2021-0119127 A1 | 22 April 2021 |

Form PCT/ISA/210 (patent family annex) (July 2022)